# EUROPEAN PATENT APPLICATION

(11) **EP 4 498 776 A1**
(43) Date of publication of application: **29.01.2025**
(21) Application number: 24167068.6
(22) Date of filing: 27.03.2024
(51) Int. Cl.: H10B 43/27, H10B 41/27

(54) **SEMICONDUCTOR MEMORY DEVICE AND ELECTRONIC SYSTEM INCLUDING THE SAME**

(30) Priority: 25.07.2023 KR 20230096632
(71) Applicant: Samsung Electronics Co., Ltd., Suwon-si, Gyeonggi-do 16677 (KR)
(72) Inventor: CHOI, Hyun-Mook, 16677 Suwon-si (KR)
(74) Representative: Marks & Clerk LLP

(57) **Abstract**

A semiconductor memory device includes a peripheral circuit structure including peripheral circuits; a stacked structure on the peripheral circuit structure and including first electrode layers and first inter-electrode insulating layers that are alternately stacked; a first vertical pattern that extends into the stacked structure; a first insulating layer on the stacked structure, a second electrode layer on the first insulating layer, and a second insulating layer on the second electrode layer; a line separation pattern that extends into the second insulating layer, the second electrode layer, and the first insulating layer; and a second vertical pattern that extends into the second insulating layer, the second electrode layer, and the first insulating layer, where the second vertical pattern is electrically connected to the first vertical pattern.

## Description

### TECHNICAL FIELD

The present disclosure relates to a semiconductor memory device and an electronic system including the same.

### BACKGROUND

There has been a demand for a semiconductor device for storing high-capacity data in an electronic system requiring data storage. Accordingly, there have been studies into measures for increasing the data storage capacity of a semiconductor device. For example, as one method for increasing data storage capacity of a semiconductor device, a semiconductor device including memory cells arranged three-dimensionally, rather than memory cells arranged two-dimensionally, has been suggested.

### SUMMARY

An object of the present disclosure is to provide a semiconductor device with improved reliability and integration.

An object of the present disclosure is to provide an electronic system including a semiconductor device with improved reliability.

The problem to be solved by the present disclosure is not limited to the problems mentioned above, and other problems not mentioned will be clearly understood by those skilled in the art from the following description.

A semiconductor memory device according to some embodiments of the present disclosure includes a peripheral circuit structure including peripheral circuits; a stacked structure on the peripheral circuit structure and including first electrode layers and first inter-electrode insulating layers that are alternately stacked; a first vertical pattern that extends into the stacked structure; a first insulating layer on the stacked structure, a second electrode layer on the first insulating layer, and a second insulating layer on the second electrode layer; a line separation pattern that extends into the second insulating layer, the second electrode layer, and the first insulating layer; and a second vertical pattern that extends into the second insulating layer, the second electrode layer, and the first insulating layer, where the second vertical pattern is electrically connected to the first vertical pattern.

A semiconductor memory device according to some embodiments of the present disclosure includes a substrate; a peripheral circuit structure including peripheral circuits that are on the substrate, the peripheral circuit structure including first bonding pads that are electrically connected to the peripheral circuits; and a cell array structure including second bonding pads that are electrically connected to the first bonding pads, where the cell array structure includes: a stacked structure including first electrode layers and first inter-electrode insulating layers that are alternately stacked; block separation patterns that extends into the stacked structure; a center separation pattern that extends into the stacked structure and is between the block separation patterns; first vertical patterns that extend into the stacked structure; a first insulating layer on the stacked structure, a second electrode layer on the first insulating layer, and a second insulating layer on the second electrode layer; a first line separation pattern that extends into the second insulating layer, the second electrode layer, and the first insulating layer, where the first line separation patterns are respectively on the block separation patterns; a second line separation pattern that extends into the second insulating layer, the second electrode layer, and the first insulating layer, where the second line separation pattern is on the center separation pattern; and second vertical patterns that extend into the second insulating layer, the second electrode layer, and the first insulating layer, where the second vertical patterns are respectively on the first vertical patterns.

An electronic system according to some embodiments of the present disclosure includes a semiconductor memory device including a substrate, a peripheral circuit structure on the substrate, and a cell array structure on the peripheral circuit structure; and a controller that is electrically connected to the semiconductor memory device through an input/output pad and is configured to control the semiconductor memory device, where the cell array structure includes: a stacked structure that is on the peripheral circuit structure and includes first electrode layers and first inter-electrode insulating layers that are alternately stacked; a first vertical pattern that extends into the stacked structure; a first insulating layer on the stacked structure, a second electrode layer on the first insulating layer, and a second insulating layer on the second electrode layer; a line separation pattern that extends into the second insulating layer, the second electrode layer, and the first insulating layer; and a second vertical pattern that extends into the second insulating layer, the second electrode layer, and the first insulating layer, where the second vertical pattern is electrically connected to the first vertical pattern.

The line separation pattern and/or first and second line separation patterns may extend into elements of the described semiconductor memory device, such as the second insulating layer, second electrode layer and first insulating layer, but not into elements or features of the stacked structure. The line separation pattern and/or first and second line separation patterns may be on the stacked structure. The line separation pattern and/or first and second line separation patterns may not extend into or penetrate the stacked structure.

At least some of the above and other features of the disclosure are set out in the claims.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1 is a diagram schematically illustrating an electronic system including a semiconductor memory device according to an embodiment of the present disclosure.
FIG. 2 is a perspective view schematically illustrating an electronic system including a semiconductor memory device according to an embodiment of the present disclosure.
FIGS. 3 and 4 are cross-sectional views schematically illustrating semiconductor packages according to an embodiment of the present disclosure.
FIG. 5 is a plan view of a semiconductor memory device according to an embodiment of the present disclosure.
FIG. 6 is a cross-sectional view of a semiconductor memory device according to an embodiment of the present disclosure, taken along line A-A' of FIG. 5.
FIG. 7 is a cross-sectional view of a semiconductor memory device according to an embodiment of the present disclosure, taken along line B-B' of FIG. 5.
FIGS. 8A, 8B, 8C, and 8D are enlarged views of'P2' in FIG. 6 according to embodiments of the present disclosure.
FIG. 9 is a cross-sectional view of a semiconductor memory device according to an embodiment of the present disclosure, taken along line A-A' of FIG. 5.
FIG. 10 is a cross-sectional view of a semiconductor memory device according to an embodiment of the present disclosure, taken along line B-B' of FIG. 5.
FIGS. 11A, 11B, 11C, 11D, 11E, 11F, 11G, and 11H are diagrams sequentially illustrating a process of manufacturing a semiconductor memory device having the cross-section of FIG. 6.
FIGS. 12A, 12B, and 12C are enlarged views of the 'P2' portion of FIG. 11E and sequentially show a process of manufacturing a semiconductor memory device having the cross-section of FIG. 6.
FIGS. 13A, 13B, and 13C are diagrams sequentially illustrating a process of manufacturing a semiconductor memory device having the cross-section of FIG. 7.

### DETAILED DESCRIPTION

To clarify the present disclosure, parts that are not connected with the description will be omitted, and the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the phrase "at least one of A, B, and C" refers to a logical (A OR B OR C) using a non-exclusive logical OR, and should not be construed to mean "at least one of A, at least one of B and at least one of C." As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof. The term "and/or" includes any and all combinations of one or more of the associated listed items. The term "connected" may be used herein to refer to a physical and/or electrical connection and may refer to a direct or indirect physical and/or electrical connection.

As used herein, "an element A is at a higher level than element B" or "an element A is at a lower level than element B" refers to at least one surface of element A that is not coplanar with at least one surface of element B and/or at least one surface of element A being spaced apart from a reference element by a different distance than element B and the reference element. As an example, "an element A is at a higher level than element B" refers to element A being spaced apart from a reference element by a greater distance than element B and the reference element. Components or layers described with reference to "overlap" in a particular direction may be at least partially obstructed by one another when viewed along a line extending in the particular direction or in a plane perpendicular to the particular direction.

Hereinafter, embodiments of the present disclosure will be described in detail with reference to the drawings.

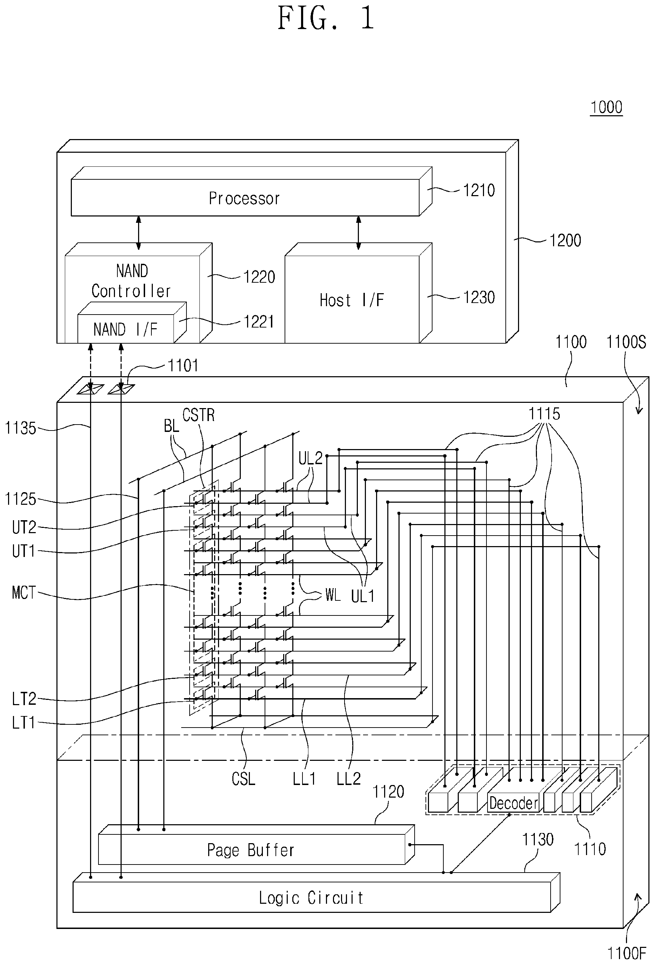

FIG. 1 is a diagram schematically illustrating an electronic system including a semiconductor memory device according to an embodiment of the present disclosure.

Referring to FIG. 1, an electronic system 1000 according to some embodiments of present disclosure may include a semiconductor device 1100 and a controller 1200, which are electrically connected to each other. The electronic system 1000 may be or may include a storage device including one or more semiconductor devices 1100 and/or an electronic device including the storage device. For example, the electronic system 1000 may be or may include at least one of a solid state drive (SSD) device, a universal serial bus (USB), a computing system, a medical system, or a communication system, in which at least one semiconductor device 1100 is provided.

The semiconductor device 1100 may be a nonvolatile memory device, such as a NAND flash memory device. The semiconductor device 1100 may include a first structure 1100F and a second structure 1100S on the first structure 1100F. As an example, the first structure 1100F may be disposed adjacent to the second structure 1100S.

The first structure 1100F may be a peripheral circuit structure including a decoder circuit 1110, a page buffer 1120, and a logic circuit 1130. The second structure 11005 may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may vary according to embodiments.

In an embodiment, at least one of the upper transistors UT1 and UT2 may include the string selection transistor, and at least one of the lower transistors LT1 and LT2 may include a ground selection transistor. The gate lower lines LL1 and LL2 may correspond to gate electrodes of the lower transistors LT1 and LT2, respectively. The word lines WL may correspond to gate electrodes of the memory cell transistors MCT, and the gate upper lines UL1 and UL2 may correspond to gate electrodes of the upper transistors UT1 and UT2, respectively.

In an embodiment, the lower transistors LT1 and LT2 may include a lower erase control transistor LT1 and a ground selection transistor LT2, which are connected in series. The upper transistors UT1 and UT2 may include a string selection transistor UT1 and an upper erase control transistor UT2, which are connected in series. At least one of the lower and upper erase control transistors LT1 and UT2 may be used for an erase operation of erasing data, which are stored in the memory cell transistors MCT, using a gate-induced drain leakage (GIDL) phenomenon.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from a region in the first structure 1100F to a region in the second structure 1100S. The bit lines BL may be electrically connected to the page buffer 1120 through second connection lines 1125, which are extended from a region in the first structure 1100F to a region in the second structure 1100S.

In the first structure 1100F, the decoder circuit 1110 and the page buffer 1120 may be configured to control an operation, which is performed on at least one of the memory cell transistors MCT by a selection memory cell transistor. The decoder circuit 1110 and the page buffer 1120 may be controlled by the logic circuit 1130. The semiconductor device 1100 may communicate with the controller 1200 through an input/output pad 1101, which is electrically connected to the logic circuit 1130. The input/output pad 1101 may be electrically connected to the logic circuit 1130 through an input/output connection line 1135, which is provided in the first structure 1100F and is extended into the second structure 1100S.

Although not shown, the first structure 1100F may include a voltage generator (not shown). The voltage generator may generate at least one of a program voltage, a read voltage, a pass voltage, a verification voltage, and so forth, which are used to operate the memory cell strings CSTR. Here, the program voltage may be a relatively high voltage (e.g., 20V to 40V), compared with any of the read voltage, the pass voltage, and the verification voltage.

In some embodiments, the first structure 1100F may include high-voltage transistors and low-voltage transistors. The decoder circuit 1110 may include pass transistors which are connected to the word lines WL of the memory cell strings CSTR. The pass transistors may include high-voltage transistors which are configured to operate at a high voltage (e.g., the program voltage applied to the word lines WL during a programming operation). The page buffer 1120 may also include high-voltage transistors configured to operate at the high voltage.

The controller 1200 may include a processor 1210, a NAND controller 1220, and a host interface 1230. In embodiments, the electronic system 1000 may include a plurality of semiconductor memory devices 1100, and in this case, the controller 1200 may control the plurality of semiconductor memory devices 1100.

The processor 1210 may control overall operations the electronic system 1000 including the controller 1200. The processor 1210 may be operated based on a specific firmware and may control the NAND controller 1220 to access the semiconductor device 1100. The NAND controller 1220 may include a NAND interface 1221, which is used to communicate with the semiconductor device 1100. The NAND interface 1221 may be used to transmit and receive control commands to control the semiconductor device 1100, data to be written in or read from the memory cell transistors MCT of the semiconductor device 1100, and so forth. The host interface 1230 may allow communication between the electronic system 1000 and an external host. When a control command is received from an external host through the host interface 1230, the processor 1210 may control the semiconductor device 1100 in response to the control command.

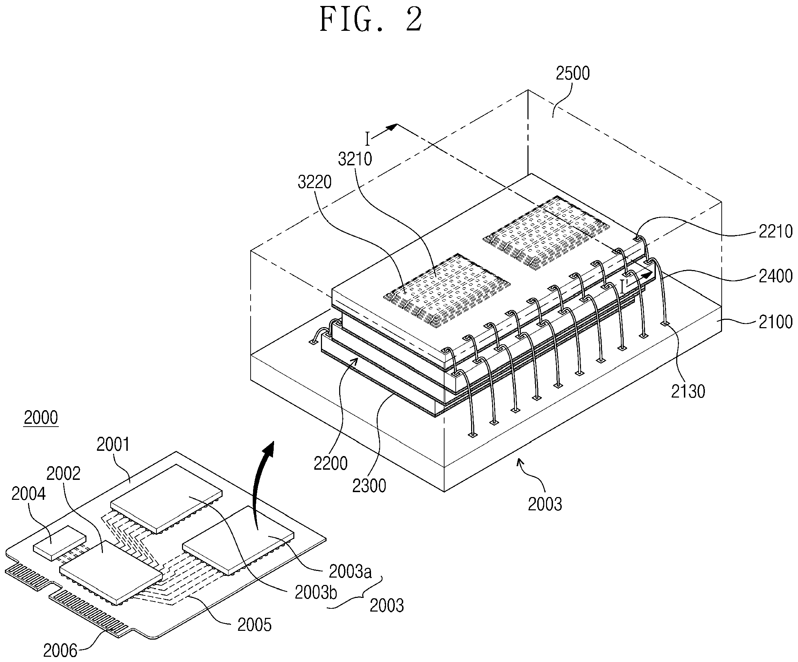

FIG. 2 is a perspective view schematically illustrating an electronic system including a semiconductor memory device according to an embodiment of the present disclosure.

Referring to FIG. 2, an electronic system 2000 according to an embodiment of the present disclosure may include a main substrate 2001 and a controller 2002, at least one semiconductor package 2003, and a DRAM 2004, which are mounted on the main substrate 2001. The semiconductor package 2003and the DRAM 2004 may be connected to the controller 2002 and to each other by wiring patterns 2005, which are formed in the main substrate 2001.

The main substrate 2001 may include a connector 2006, which includes a plurality of pins coupled to an external host. In the connector 2006, the number and arrangement of the pins may depend on a communication interface between the electronic system 2000 and the external host. In an embodiment, the electronic system 2000 may communicate with the external host in accordance with known interfaces, such as universal serial bus (USB), peripheral component interconnect express (PCI-Express), serial advanced technology attachment (SATA), universal flash storage (UFS) M-Phy, or the like. In an embodiment, the electronic system 2000 may be driven by a power that is supplied from the external host through the connector 2006. The electronic system 2000 may further include a Power management integrated circuit (PMIC) that distributes power, which is supplied from the external host, to the controller 2002 and the semiconductor package 2003.

The controller 2002 may control a writing or reading operation on the semiconductor package 2003 and an operation speed of the electronic system 2000 may be improved.

The DRAM 2004 may be a buffer memory, which relieves technical difficulties caused by a difference in speed between the semiconductor package 2003, which serves as a data storage device, and an external host. In an embodiment, the DRAM 2004 in the electronic system 2000 may serve as a cache memory and may provide a storage space to temporarily store data during a control operation on the semiconductor package 2003. In the case where the electronic system 2000 includes the DRAM 2004, the controller 2002 may further include a DRAM controller to control the DRAM 2004, in addition to a NAND controller to controlling the semiconductor package 2003.

The semiconductor package 2003 may include first and second semiconductor packages 2003a and 2003b, which are spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 disposed on respective bottom surfaces of the semiconductor chips 2200, a connection structure 2400 electrically connecting the semiconductor chips 2200 to the package substrate 2100, and a molding layer 2500 disposed on the package substrate 2100 to cover the semiconductor chips 2200 and the connection structure 2400.

The package substrate 2100 may be a printed circuit board including package upper pads 2130. Each of the semiconductor chips 2200 may include an input/output pad 2210. The input/output pad 2210 may correspond to the input/output pad 1101 of FIG. 1. Each of the semiconductor chips 2200 may include gate stacks 3210 and vertical structures 3220. Each of the semiconductor chips 2200 may include a semiconductor device, which will be described below, according to an embodiment of the present disclosure.

In an embodiment, the connection structure 2400 may be a bonding wire electrically connecting the input/output pad 2210 to the package upper pads 2130. Thus, in each of the first and second semiconductor packages 2003a and 2003b, the semiconductor chips 2200 may be electrically connected to each other in a bonding wire manner and may be electrically connected to the package upper pads 2130 of the package substrate 2100. In other embodiments, the semiconductor chips 2200 in each of the first and second semiconductor packages 2003a and 2003b may be electrically connected to each other by a connection structure including through silicon vias (TSV) as opposed to the connection structure 2400 provided in the form of bonding wires.

In an embodiment, the controller 2002 and the semiconductor chips 2200 may be included in a single package. In an embodiment, the controller 2002 and the semiconductor chips 2200 may be mounted on a separate interposer substrate, which is prepared regardless of the main substrate 2001, and may be connected to each other through wirings, which are provided in the interposer substrate.

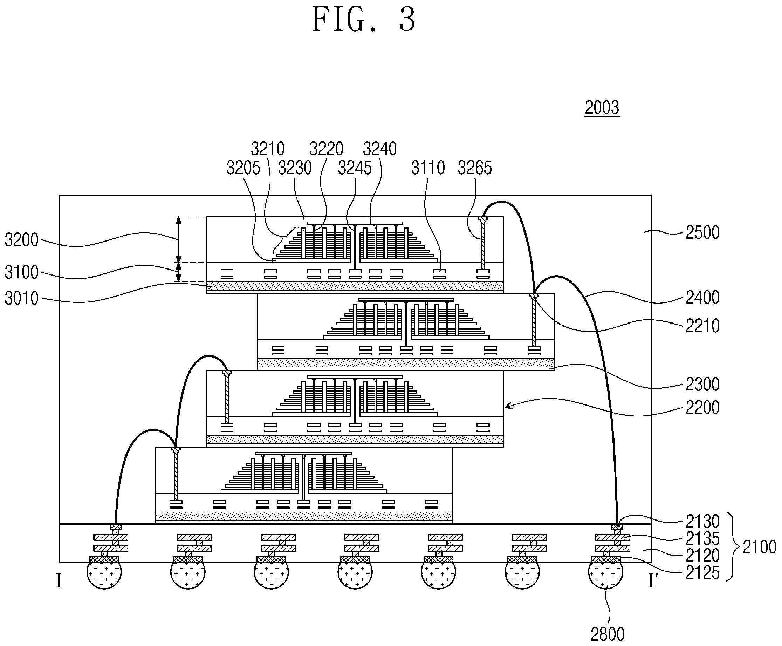

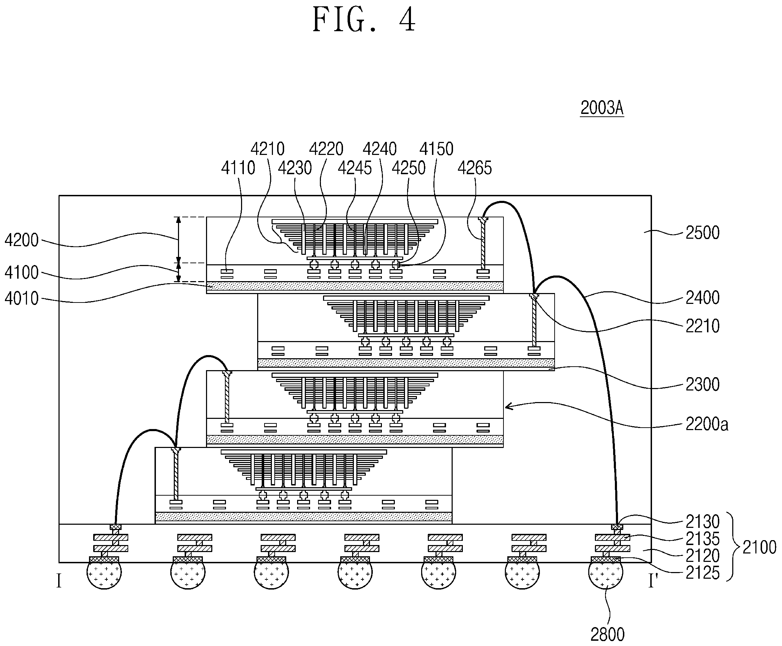

FIGS. 3 and 4 are cross-sectional views illustrating semiconductor packages according to an embodiment of the present disclosure. FIGS. 3 and 4 are sectional views, which are taken along a line I-I' of FIG. 2, and conceptually illustrate embodiments of the semiconductor package of FIG. 2.

Referring to FIG. 3, in the semiconductor package 2003, the package substrate 2100 may be a printed circuit board. The package substrate 2100 may include a package substrate body portion 2120, the package upper pads 2130 (e.g., of FIG. 2) that are disposed on an upper surface of the package substrate body portion 2120, lower pads 2125 that are disposed on or exposed through a bottom surface of the package substrate body portion 2120, and internal lines 2135 that are provided in the package substrate body portion 2120 to electrically connect the package upper pads 2130 to the lower pads 2125. The package upper pads 2130 may be electrically connected to the connection structures 2400. The lower pads 2125 may be connected to the wiring patterns 2005, which are provided in the main substrate 2001 of the electronic system 2000, through conductive connecting portions 2800, as shown in FIG. 2.

Each of the semiconductor chips 2200 may include a semiconductor substrate 3010 and first and second structures 3100 and 3200, which are sequentially stacked on the semiconductor substrate 3010. The first structure 3100 may include a peripheral circuit region in which peripheral lines 3110 are provided. The second structure 3200 may include a source structure 3205, the stack 3210 on the source structure 3205, the vertical structures 3220 and separation structures 3230 extending into the stack 3210, bit lines 3240 electrically connected to the vertical structures 3220, and cell contact plugs 3265 electrically connected to the word lines WL (e.g., of FIG. 1) of the stack 3210. Each of the first and second structures 3100 and 3200 and the semiconductor chips 2200 may further include separation structures to be described below.

Each of the semiconductor chips 2200 may include penetration lines 3245, which are electrically connected to the peripheral lines 3110 of the first structure 3100 and are extended into the second structure 3200. The penetration line 3245 may be disposed outside the stack 3210, and in an embodiment, the penetration line 3245 may be provided to extend into the stack 3210. Each of the semiconductor chips 2200 may further include the input/output pad 2210 (e.g., see FIG. 2), which are electrically connected to the peripheral lines 3110 of the first structure 3100.

Referring to FIG. 4, in a semiconductor package 2003A, each of semiconductor chips 2200a may include a semiconductor substrate 4010, a first structure 4100 on the semiconductor substrate 4010, and a second structure 4200 that is on the first structure 4100 and is bonded with the first structure 4100 in a wafer bonding manner.

The first structure 4100 may include a peripheral circuit region, in which a peripheral line 4110 and first junction structures 4150 are provided. The second structure 4200 may include a source structure 4205, a stack 4210 between the source structure 4205 and the first structure 4100, vertical structures 4220 and a separation structure 4230 that extend into the stack 4210, and second junction structures 4250 that are respectively and electrically connected to the vertical structures 4220 and the word lines WL (e.g., of FIG. 1) of the stack 4210. For example, the second junction structures 4250 may be electrically and respectively connected to the vertical structures 4220 and the word lines WL (e.g., of FIG. 1) through bit lines 4240, which are electrically connected to the vertical structures 4220, and cell contact plugs 4235, which are electrically connected to the word lines WL (e.g., of FIG. 1). The first junction structures 4150 of the first structure 4100 may be in contact with and coupled to the second junction structures 4250 of the second structure 4200. The coupled portions of the first junction structures 4150 and the second junction structures 4250 may be formed of or include, for example, copper (Cu).

Each of the first and second structures 4100 and 4200 and the semiconductor chips 2200a may further include a source structure, as will be described below with reference to an embodiment. Each of the semiconductor chips 2200a may further include the input/output pads 2210 (e.g., of FIG. 2), which are electrically connected to the peripheral lines 4110 of the first structure 4100.

The semiconductor chips 2200 or 2200 a of FIG. 3 or 4 may be electrically connected to each other by the connection structures 2400, which are provided in the form of bonding wires. However, in an embodiment, semiconductor chips, which are provided in the same semiconductor package as the semiconductor chips 2200 or 2200 a of FIG. 3 or 4, may be electrically connected to each other by a connection structure including through silicon vias (TSV).

The first structure 3100 of FIG. 3 and the first structure 4100 of FIG. 4 may correspond to a peripheral circuit structure in an embodiment to be described below, and the second structure 3200 of FIG. 3 and the second structure 4200 of FIG. 4 may correspond to a cell array structure in an embodiment to be described below.

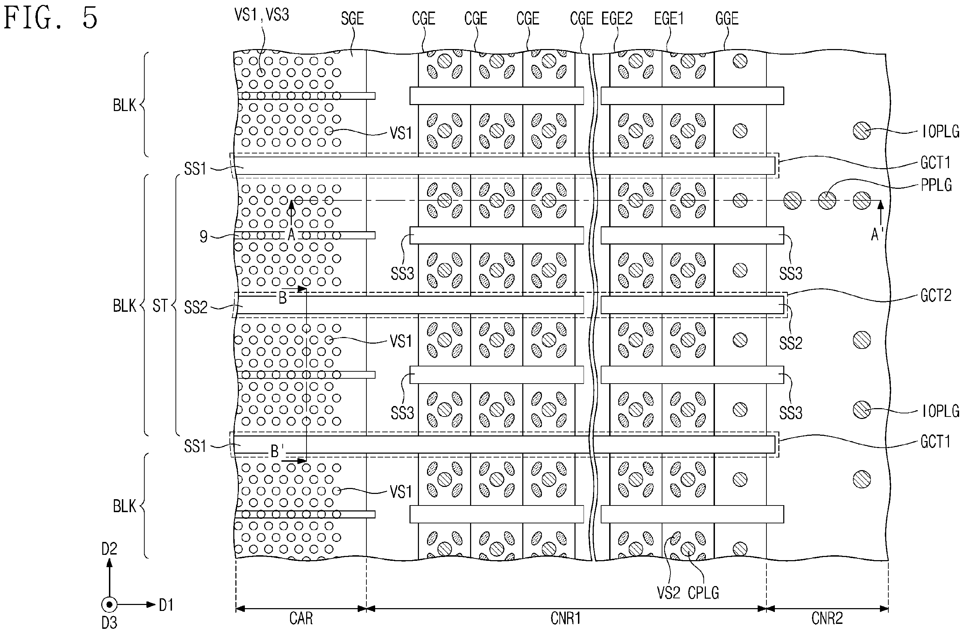

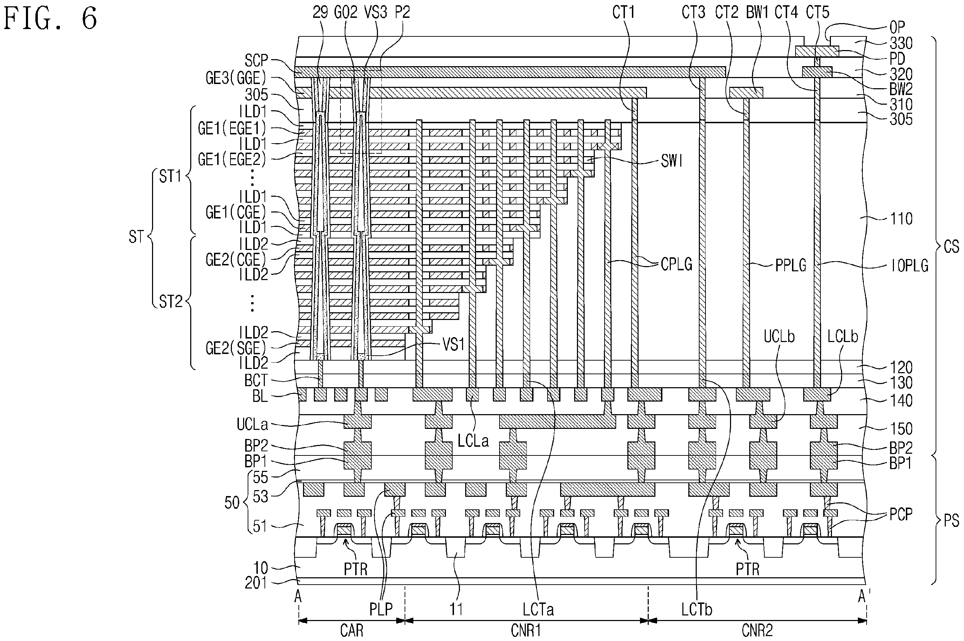

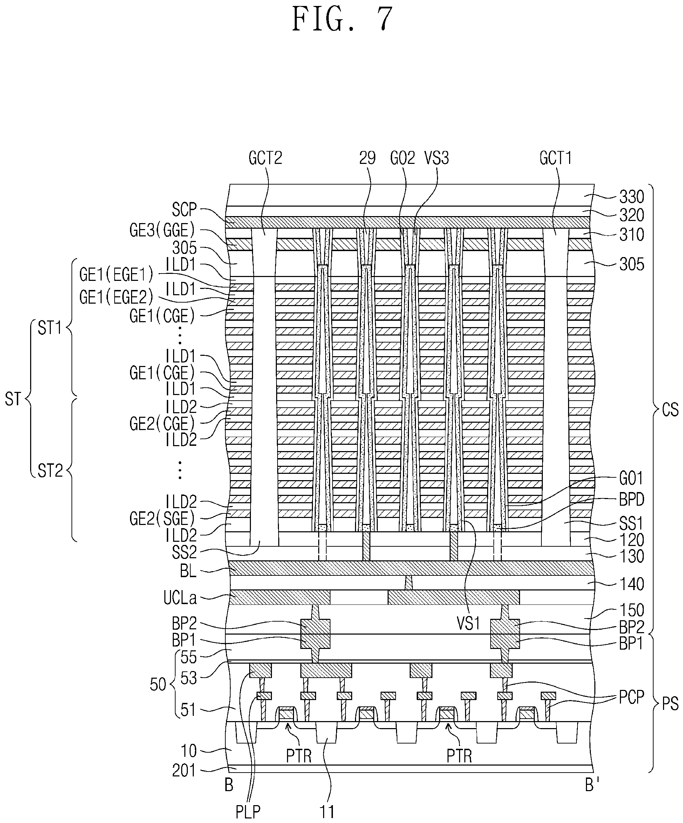

FIG. 5 is a plan view of a semiconductor memory device according to an embodiment of the present disclosure. FIG. 6 is a cross-sectional view of a semiconductor memory device according to an embodiment of the present disclosure, taken along line A-A' of FIG. 5. FIG. 7 is a cross-sectional view of a semiconductor memory device according to an embodiment of the present disclosure, taken along line B-B' of FIG. 5.

Referring to FIGS. 5, 6, and 7, a semiconductor memory device according to an embodiment of the present disclosure may include a substrate 10, a peripheral circuit structure PS on the substrate 10, and a cell array structure CS on the peripheral circuit structure PS.

According to embodiments, the cell array structure CS may be coupled on the peripheral circuit structure PS to increase a cell capacity per unit area of the semiconductor memory device according to the present disclosure. In addition, the peripheral circuit structure PS and the cell array structure CS may be separately manufactured and coupled to each other, and thus damage to the peripheral circuits PTR due to various heat treatment processes may be inhibited, thereby improving electrical characteristics and reliability of the semiconductor memory device according to the present disclosure.

In detail, the peripheral circuit structure PS may be integrated on a front surface of the substrate 10, and may include peripheral circuits PTR that control the memory cell array, peripheral contact plugs PCP, peripheral circuit wirings PLP electrically connected to peripheral circuits PTR through peripheral contact plugs PCP, first bonding pads BP1 electrically connected to the peripheral circuit wirings PLP, and a lower insulating layer 50 at least partially surrounding at least one of the peripheral circuits PTR, the peripheral contact plugs PCP, the peripheral circuit wirings PLP, and the first bonding pads BP1.

The substrate 10 may be, for example, a silicon substrate, a silicon-germanium substrate, a germanium substrate, or a single crystalline epitaxial layer grown on a monocrystalline silicon substrate. The substrate 10 may have an upper surface parallel to a first direction D1 and a second direction D2 that intersects the first direction D1 and is orthogonal to a third direction D3. For example, the first to third directions D1, D2, and D3 may be directions orthogonal to each other. A device isolation layer 11 may be provided within the substrate 10. The device isolation layer 11 may define the active region of the substrate 10.

The peripheral circuits PTR may include row and column decoders, page buffers, and control circuits described with reference to FIG. 1. In detail, the peripheral circuits PTR may include NMOS and PMOS transistors. Transistors constituting the peripheral circuits PTR may be provided on the active region of the substrate 10.

For example, a width of the peripheral contact plugs PCP may increase in the first direction D1 or the second direction D2 as the peripheral contact plugs PCP extend in the third direction D3. The peripheral contact plugs PCP and peripheral circuit wirings PLP may include a conductive material such as metal.

The lower insulating layer 50 may include insulating layers stacked in multiple layers. For example, the lower insulating layer 50 may include a silicon oxide layer, a silicon nitride layer, a silicon oxynitride layer, and/or a low dielectric layer. As an example, the lower insulating layer 50 may include a first lower insulating layer 51, a second lower insulating layer 55, and an etch stop layer 53 between the first and second lower insulating layers 51 and 55. The etch stop layer 53 may include an insulating material different from the first and second lower insulating layers 51 and 55, and may cover or overlap upper surfaces of the uppermost peripheral circuit wiring PLP. Additionally, a surface insulating layer 201 may be provided on a lower surface of the substrate 10.

The first bonding pads BP1 may be disposed in the uppermost lower insulating layer 50. The lower insulating layer 50 may not cover/overlap upper surfaces of the first bonding pads BP1. An upper surface of the uppermost lower insulating layer 50 may be substantially coplanar with the upper surfaces of the first bonding pads BP1. The first bonding pads BP1 may be electrically connected to the peripheral circuits PTR through peripheral circuit wirings PLP and peripheral contact plugs PCP.

The cell array structure CS may be provided on the peripheral circuit structure PS. The cell array structure CS of the semiconductor memory device may include a cell array region CAR, a first connection region CNR1, and a second connection region CNR2 that are adjacent to each other in the first direction D1.

The cell array structure CS may include a memory cell array including memory cells that are three-dimensionally arranged. The cell array structure CS may include a source conductive pattern SCP, a third electrode layer GE3, a stacked structure ST, first and second vertical patterns VS1 and VS2, third vertical patterns VS3, bit lines BL, cell contact plugs CPLG, peripheral contact plugs PPLG, and input/output contact plugs IOPLG. The third electrode layer GE3 may be a ground selection gate pattern GGE. The ground select gate pattern GGE may also be called a ground select line. The "vertical pattern" in the first vertical pattern VS1 and the third vertical pattern VS3 may also be called a "vertical semiconductor pattern" or a "vertical channel pattern".

The plurality of stacked structures ST may extend in the first direction D1 and be spaced apart from each other in the second direction D2 when viewed in a plan view of FIG. 5. Hereinafter, for convenience of explanation, a single stacked structure ST will be described, but the following description may be applied to other stacked structures ST.

The stacked structure ST may include first and second electrode layers GE1 and GE2 and first and second inter-electrode insulating layers ILD1 and ILD2 that alternately are stacked in the third direction D3 (i.e., vertical direction).

In embodiments, the first electrode layers GE1 may include first and second erase gate patterns EGE1 and EGE2 adjacent to the third electrode layer GE3, and a plurality of cell gate patterns CGE below the second erase gate pattern EGE2. The second electrode layers GE2 may include a plurality of cell gate patterns CGE and a string select gate pattern SGE below the lowermost cell gate pattern CGE.

The erase control gate patterns EGE1 and EGE2 may be adjacent to the third electrode layer GE3, and may correspond to gate patterns of erase control transistors LT1 or LT2 (in FIG. 1) that control the erase operation by generating gate induced drain leakage (GIDL) of the memory cell array. The ground selection gate pattern GGE, which is the third electrode layer (GE3), may correspond to gate patterns of ground selection transistors LT1 or LT2 (in FIG. 1) that control the electrical connection between the common source line CSL (in FIG. 1) and the vertical channel. The cell gate patterns CGE may correspond to word lines WL (in FIG. 1) of memory cell transistors MCT (in FIG. 1). The string selection gate patterns SGE of the uppermost layer may correspond to a gate pattern of the string selection transistor UT1 or UT2 (in FIG. 1) that controls the electrical connection between the bit line BL and the first vertical patterns VS1.

In another example, the first electrode layers GE1 may exclude the first and second erase gate patterns EGE1 and EGE2. The first electrode layers GE1 may include only cell gate patterns CGE. Some of the second electrode layers GE2 may serve as an erase gate.

Referring again to FIGS. 5 to 7, the first and second electrode layers GE1 and GE2 of the stacked structure ST may be stacked to have an inverted staircase structure in the first connection region CNR1. That is, a length of the first and second electrode layers GE1 and GE2 may increase in the first direction D1 as a distance from the peripheral circuit structure PS increases.

The first and second electrode layers GE1 and GE2 and the third electrode layer GE3 may each include a pad portion in the first connection region CNR1. Pad portions of each of the first and second electrode layers GE1 and GE2 and the third electrode layer GE3 may be positioned at different horizontal and vertical positions. The cell contact plugs CPLG may be connected to pad portions of the first and second electrode layers GE1 and GE2 and the third electrode layer GE3, respectively.

In embodiments, the stacked structure ST may include a first stacked structure ST1 and a second stacked structure ST2 on the first stacked structure ST1. The first stacked structure ST 1 may include first inter-electrode insulating layers ILD1 and first electrode layers GE1 that are alternately stacked, and the second stacked structure ST2 may include second inter-electrode insulating layers ILD2 and second electrode layers GE2 that are alternately stacked.

The second stacked structure ST2 may be disposed between the first stacked structure ST1 and the peripheral circuit structure PS. In detail, the second stacked structure ST2 may be provided under the lowermost one of the first inter-electrode insulating layers ILD1 of the first stacked structure ST1. The uppermost one of the second inter-electrode insulating layers ILD2 of the second stacked structure ST2 and the lowermost one of the first inter-electrode insulating layers ILD1 of the first stacked structure ST1 may be in contact with each other but the present disclosure is not limited thereto. A single-layer insulating layer may be provided between the uppermost of the second electrode layers GE2 of the second stacked structure ST2 and the lowermost of the first electrode layers GE1 of the first stacked structure ST1.

The lowermost one of the second electrode layers GE2 of the second stacked structure ST2 may have the smallest length in the first direction D1, and the uppermost one of the first electrode layers GE1 of the first stacked structure ST1 may have the largest length in the first direction D1.

The first and second electrode layers GE1 and GE2 and the third electrode layer GE3 may include, for example, at least one selected from a semiconductor doped with impurities (e.g., silicon doped with an impurity, etc.), a metal (e.g., tungsten, molybdenum, nickel, copper, aluminum, etc.), conductive metal nitrides (e.g., titanium nitride, tantalum nitride, etc.), or transition metals (e.g., titanium, tantalum, etc.). According to one example, the first and second electrode layers GE1 and GE2 may be formed of a metal, such as tungsten, and the third electrode layer GE3 may be formed of polysilicon doped with impurities.

The first and second inter-electrode insulating layers ILD1 and ILD2 may include silicon oxide, silicon nitride, silicon oxynitride, and/or a low dielectric material. For example, the first and second inter-electrode insulating layers ILD1 and ILD2 may include high-density plasma oxide (HDP oxide) or tetraethylorthosilicate (TEOS).

According to embodiments, the semiconductor memory device may be a vertical NAND flash memory device, and in this case, the first and second electrode layers GE1 and GE2 of the stacked structure ST may correspond to gate lower lines LL1 and LL2, word lines WL, and gate upper lines UL1 and UL2 as described with reference to FIG. 1.

The third electrode layer GE3 may correspond to one of the gate lower lines LL1 and LL2 or a ground selection line described with reference to FIG. 1. The third electrode layer GE3 may extend along the first and second electrode layers GE1 and GE2. In the present example, the third electrode layer GE3 is shown as one layer, but it is not limited to this example and may be composed of two or more layers. Additionally, a role of the third electrode layer GE3 is not limited to the ground selection line and may also participate in an erase operation.

A flat insulating layer 110 may cover or overlap the ends (i.e., pad portions) of the stacked structure ST having a stepped structure. The flat insulating layer 110 may have a substantially flat upper surface. The flat insulating layer 110 may include one insulating layer or a plurality of stacked insulating layers. The flat insulating layer 110 may have substantially flat upper and lower surfaces. The upper surface of the flat insulating layer 110 may be substantially coplanar with an upper surface of the first inter-electrode insulating layer ILD1 at the uppermost end of the stacked structure ST, and the lower surface of the flat insulating layer 110 may be substantially coplanar with a lower surface of the second inter-electrode insulating layer ILD2 at the lowermost one of the stacked structure ST.

A first insulating layer 305 may be interposed between the stacked structure ST and the third electrode layer GE3. A first wiring BW1 is disposed on the first insulating layer 305. The third electrode layer GE3 and the first wiring BW1 may be formed of the same material and have the same thickness. The third electrode layer GE3 and the first wiring BW1 may be covered or overlapped with the second insulating layer 310. A source conductive pattern SCP and a second wiring BW2 are disposed on the second insulating layer 310. The source conductive pattern SCP and the second wiring BW2 may be formed of the same material and have the same thickness. For example, the source conductive pattern SCP and the second wiring BW2 may include at least one selected from metal (e.g., tungsten, copper, aluminum, etc.), conductive metal nitride (e.g., titanium nitride, tantalum nitride, etc.), or transition metal (e.g., titanium, tantalum, etc.).

The source conductive pattern SCP may have a uniform thickness and a substantially flat upper surface. The source conductive pattern SCP may extend in the first direction D1 that is parallel to the stacked structure ST in the cell array region CAR and the first connection region CNR1. In the first direction D1, a length of the source conductive pattern SCP may be greater than a length of the uppermost first electrode layer GE1 of the first stacked structure ST1.

Source conductive patterns SCP may include, for example, at least one selected from a doped semiconductor (e.g., doped silicon, etc.), a metal (e.g., tungsten, molybdenum, nickel, copper, aluminum, etc.), a conductive metal nitride (e.g., titanium nitride, tantalum nitride, etc.), or a transition metal (e.g., titanium, tantalum, etc.). As an example, the source conductive pattern SCP may include a metal material (e.g., tungsten). The source conductive pattern SCP may correspond to the common source line CSL of FIG. 1.

A plurality of first vertical patterns VS1 may extend into the stacked structure ST in the cell array region CAR and be connected to the source conductive pattern SCP. When viewed in a plan view, the first vertical patterns VS1 may be arranged in one direction or in a zigzag shape. The first vertical patterns VS1 may include a semiconductor material, such as silicon. The first vertical patterns VS1 may serve as a channel for at least one of the memory cell transistors MCT, upper transistors UT1 and UT2, and lower transistors LT1 and LT2 of FIG. 1.

The second vertical patterns VS2 may extend into the stacked structure ST in the first connection region CNR1. The second vertical patterns VS2 may extend into the ends (i.e., pad portions) of the first and second electrode layers GE1 and GE2 in the first connection region CNR1. The second vertical patterns VS2 may include the same semiconductor material as the first vertical patterns VS1, or may include an insulating material different from the first vertical patterns VS1. The second vertical patterns VS2 may serve as a support during the manufacturing process of the stacked structure ST.

A planar shape and size of the second vertical patterns VS2 may be different from those of the first vertical patterns VS1. Upper surfaces of the second vertical patterns VS2 may have various shapes, such as circular, oval, or bar shapes. The second vertical patterns VS2 may be disposed around each cell contact plug CPLG. When the upper surfaces of the second vertical patterns VS2 have an oval shape, long axes of the second vertical patterns VS2 in each pad portion PAD may be arranged in different directions. A plurality of second vertical patterns VS2 may be provided between adjacent cell contact plugs CPLG.

In embodiments, each of the first vertical patterns VS1 may be provided in a vertical channel hole extending into the stacked structure ST. In embodiments, the vertical channel hole may include a first vertical channel hole extending into the first stacked structure ST1 and second vertical channel holes extending into the second stacked structure ST2 and connected to the first vertical channel holes.

Each of the first vertical patterns VS1 may include a first vertical extension within the first vertical channel hole and a second vertical extension within the second vertical channel hole. The first vertical extension and the second vertical extension may be one structure that extends continuously without an interface. In this case, the first vertical extension may have a side wall with a uniform slope from a lower portion thereof to an upper portion thereof. Likewise, the second vertical extension may have a side wall with a uniform slope from a lower portion thereof to an upper portion thereof. That is, a width of each of the first and second vertical extensions in the first direction D1 or the second direction D2 may decrease as a distance from the substrate 10 increases. A portion where the first vertical extension and the second vertical extension are connected to each other may have different diameters. A step may be formed at the portion where the first vertical extension and the second vertical extension are connected to each other.

However, the present disclosure is not limited thereto, and in one variation, each first vertical pattern VS1 may have three or more vertical extensions each having a step at two or more interfaces. As another example, each first vertical pattern VS1 may have no steps and may have flat sidewalls.

Referring to FIGS. 5 to 7, the stacked structure ST of the cell array structure CS may be divided into (memory) blocks BLK by block separation patterns SS1. A first center separation pattern SS2 may extend into the stacked structure ST at a center of one block BLK. A second center separation pattern SS3 may be disposed between the block separation pattern SS1 and the first center separation pattern SS2, which are adjacent to each other, and may extend into the stacked structure ST.

The block separation patterns SS1, the first center separation pattern SS2, and the second center separation pattern SS3 may each have a single-layer or multi-layer structure of at least one of silicon oxide, silicon nitride, and silicon oxynitride.

The block separation patterns SS1 may extend in parallel from the cell array region CAR to the first connection region CNR1 in the first direction D1, and may be spaced apart from each other in the second direction D2. The block separation patterns SS1 may have the shape of a continuous line without a step in the first direction D1.

The first center separation pattern SS2 may have a continuous line shape in the first direction D1 in the cell array region CAR. The first center separation pattern SS2 may extend into the first connection region CNR1. However, the first center separation pattern SS2 may be cut off at the first connection region CNR1 and have a discontinuous section. Accordingly, the cell gate patterns CGE associated with one block BLK may be connected in the discontinuous section at the corresponding height and be in an equipotential state.

The second center separation pattern SS3 has a line shape extending from the first connection region CNR1 in the first direction D1, and has discontinuous sections. That is, a plurality of second center separation patterns SS3 may be provided and may be arranged to be spaced apart from each other in the first direction D1.

Referring to FIG. 5, a string line separation pattern 9 is disposed between the block separation pattern SS1 and the first center separation pattern SS2 in the cell array region CAR. The string line separation pattern 9 may be positioned at the same distance from the block separation pattern SS1 and the first center separation pattern SS2. The string line separation pattern 9 may extend through the lowermost one of the second electrode layers GE2 and separate the lowermost one of the second electrode layers GE2 into a plurality of string selection gate patterns SGE. The string line separation pattern 9 may have a single-layer or multi-layer structure of at least one of silicon oxide, silicon nitride, and silicon oxynitride. The string line separation pattern 9 may have a line shape extending from the cell array region CAR in the first direction D1. The string line separation pattern 9 may be interposed between some of the first vertical patterns VS1. Alternatively, the string line separation pattern 9 may extend into some of the first vertical patterns VS1. The first vertical patterns VS1 that are disposed in the string line separation pattern 9 or are extended into by the string line separation pattern 9 may not operate as a channel for a memory cell but may be dummy channels. The string line separation pattern 9 may be adjacent to the second center separation patterns SS3 in the first direction D1. The string line separation pattern 9 does not extend into the cell gate patterns CGE.

The first line separation pattern GCT1 may extend into the second insulating layer 310, the third electrode layer GE3, and the first insulating layer 305 and may be in contact with the block separation pattern SS1. The second line separation pattern GCT2 may extend into the second insulating layer 310, the third electrode layer GE3, and the first insulating layer 305 and may be in contact with the first center separation pattern SS2. The first line separation pattern GCT1 and the second line separation pattern GCT2 separate the third electrode layer GE3 into a plurality of ground selection gate patterns GGE or ground selection lines GGE.

In the semiconductor memory device according to the present disclosure, the first and second line isolation patterns GCT1 and GCT2 that separate the ground selection lines GGE may be disposed on the stacked structure ST, and thus the first and second electrode layers GE1 and GE2 of the stacked structure ST may be formed to be flat. This may prevent seagull shape word line contact defects and may improve reliability of the semiconductor memory device.

The first line separation pattern GCT1 and the second line separation pattern GCT2 may extend in parallel from the cell array region CAR to the first connection region CNR1 in the first direction D1, and may be spaced apart from each other in the second direction D2. The first line separation pattern GCT1 and the second line separation pattern GCT2 may have the shape of a continuous line without a step in the first direction D1. The first line separation pattern GCT1 and the second line separation pattern GCT2 may be coplanar with an upper surface of the second insulating layer 310.

First, second, third, and fourth interlayer insulating layers 120, 130, 140, and 150 may be disposed between the peripheral circuit structure PS and the stacked structure ST and between the peripheral circuit structure PS and the flat insulating layer 110. The first to fourth interlayer insulating layers 120, 130, 140, and 150 may be sequentially stacked on the flat insulating layer 110. The first interlayer insulating layer 120 may cover or overlap lower surfaces of the first and second vertical patterns VS1 and VS2. The first, second, third, and fourth interlayer insulating layers 120, 130, 140, and 150 may include silicon oxide, silicon nitride, silicon oxynitride, and/or a low dielectric material.

The bit lines BL, lower contacts LCTa and LCTb, lower conductive lines LCLa and LCLb, upper conductive lines UCLa and UCLb, and second bonding pads BP2 may be disposed in the second, third, and fourth interlayer insulating layers 120, 130, 140, and 150.

In the plan view of FIG. 5, the bit lines are omitted. Referring to FIGS. 6 and 7, the bit lines BL may be disposed on the second interlayer insulating layer 130 in the cell array region CAR and may extend in the second direction D2 across the stacked structure ST. The bit lines BL may be electrically connected to the first vertical patterns VS1 through bit line contact plugs BCT. A bit line conductive pad BPD may be formed at a lower end of the first vertical pattern VS1, and bit line contact plugs BCT may be in contact with the bit line conductive pad BPD. The bit line conductive pad BPD may be formed of a semiconductor material undoped with impurities, a semiconductor material doped with impurities, or a conductive material.

Referring to FIG. 6, the cell contact plugs CPLG may extend into the first interlayer insulating layer 120, the flat insulating layer 110, and an end of the stacked structure ST to be connected to corresponding pad portions of the first and second electrode layers GE1 and GE2. The cell contact plugs CPLG may be in direct contact with the corresponding one of the first and second electrode layers GE1 and GE2, but a contact insulating layer SW1 may be interposed between the non-corresponding first and second electrode layers GE1 and GE2 and the cell contact plugs CPLG. The contact insulating layer SW1 may have a single-layer or multi-layer structure of at least one of silicon oxide, silicon nitride, and silicon oxynitride. Cell contact plugs CPLG may have the same height (or vertical length) as each other. The outermost one of the cell contact plugs CPLG is connected to the third electrode layer GE3.

The peripheral contact plugs PPLG and the input/output contact plugs IOPLG penetrate the first and second interlayer insulating layers 120 and 130 and the flat insulating layer 110 in the second connection region CNR2 to be connected to the first wirings BW1 and the second wiring BW2.

Each of the cell contact plugs CPLG, peripheral contact plugs PPLG, and input/output contact plugs IOPLG may include a barrier metal layer including a conductive metal nitride (e.g., titanium nitride, tantalum nitride, etc.) and a metal layer containing a metal (e.g., tungsten, titanium, tantalum, etc.).

The first lower contact LCTa is disposed in the second interlayer insulating layer 130 of the first connection region CNR1. First lower conductive lines LCLa may be disposed under the second interlayer insulating layer 130 in the first connection region CNR1 and may be connected to the cell contact plugs CPLG through the first lower contact LCTa.

The second lower contact LCTb is disposed in the second interlayer insulating layer 130 of the second connection region CNR2. Second lower conductive lines LCLb may be disposed under the second interlayer insulating layer 130 of the second connection region CNR2 and may be connected to the peripheral and input/output contact plugs PPLG and IOPLG through the second lower contact LCTb.

The first and second upper conductive lines UCLa and UCLb may be disposed under the third interlayer insulating layer 140. The first upper conductive lines UCLa may be electrically connected to the bit lines BL in the cell array region CAR. The second upper conductive lines UCLb may be electrically connected to the second lower conductive lines LCLb in the first and second connection regions CNR1 and CNR2.

The first and second lower conductive lines LCLa and LCLb and the first and second upper conductive lines UCLa and UCLb may include at least one selected from a metal (e.g., tungsten, copper, aluminum, etc.), a conductive metal nitride (e.g., titanium nitride, tantalum nitride, etc.) or a transition metal (e.g., titanium, tantalum, etc.). For example, the first and second lower conductive lines LCLa and LCLb may be formed of tungsten with relatively high electrical resistivity, and the first and second upper conductive lines UCLa and UCLb may be formed of copper with relatively low electrical resistivity.

Second bonding pads BP2 may be provided in the uppermost interlayer insulating layer 150. The second bonding pads BP2 may be electrically connected to the first and second upper conductive lines UCLa and UCLb. The second bonding pads BP2 may be formed of aluminum, copper, or tungsten.

The second bonding pads BP2 may be electrically and physically connected to the first bonding pads BP1 through a bonding manner. That is, the second bonding pads BP2 may be in direct contact with the first bonding pads BP1.

The second bonding pads BP2 may include the same metal material as the first bonding pads BP1. A width of the second bonding pads BP2 may be the same as or different from a width of the first bonding pads BP1.

Referring to FIG. 6, the outermost one of the cell contact plugs CPLG is connected to the pad portion of the third electrode layer GE3 by the first contact CT1 extending into the first insulating layer 305. The second contact CT2 may extend into the first insulating layer 305 and may connect one of the peripheral contact plugs PPLG to the first wiring BW1. The third contact CT3 may extend into the first insulating layer 305 and the second insulating layer 310 to connect another one of the peripheral contact plugs PPLG to the source conductive pattern SCP. The fourth contact CT4 may extend into the first insulating layer 305 and the second insulating layer 310 to connect one of the input/output contact plugs IOPLG to the second wiring BW2.

The source conductive pattern SCP and the second wiring BW2 may be covered or overlapped with the third insulating layer 320. An input/output pad PD may be disposed on the third insulating layer 320. A passivation layer 330 may be disposed on the third insulating layer 320. The first to third insulating layers 305, 310, and 320 may each have a single-layer or multi-layer structure of at least one of silicon oxide, silicon nitride, silicon oxynitride, and silicon carbonitride. The passivation layer 330 may be, for example, a polyimide-based material such as photo sensitive polyimide (PSPI). The passivation layer 330 may have a pad opening OP that exposes a portion of the input/output pad PD. A fifth contact CT5 may penetrate the third insulating layer 320 and connect the second wiring BW2 to the input/output pad PD.

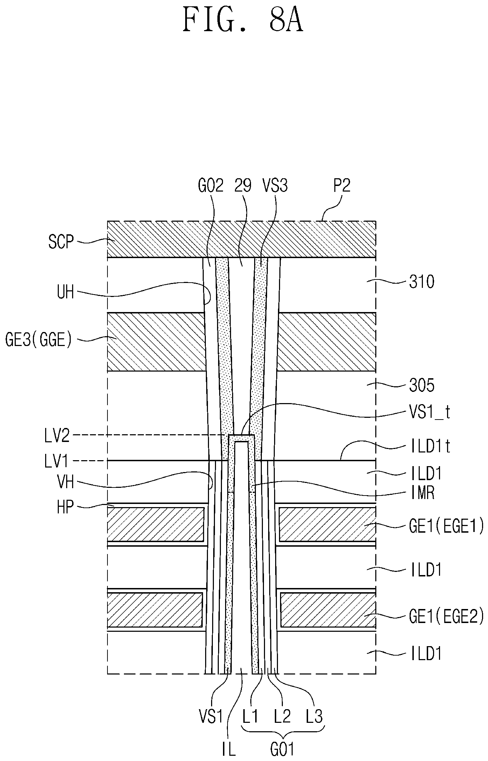

FIGS. 8A to 8D are enlarged views of 'P2' in FIG. 6 according to embodiments of the present disclosure.

Referring to FIG. 8A, the first vertical patterns VS1 are disposed in the vertical channel hole VH extending into the stacked structure ST. The first vertical patterns VS1 may be formed of a semiconductor layer (e.g., a silicon layer or a germanium layer) doped or undoped with impurities. The first vertical patterns VS1 may have a nonlinear shape (e.g., a pipe shape, a macaroni shape, or a shell shape with open tops and/or bottoms). A first impurity region IMR may be disposed on the first vertical patterns VS1. The first impurity region IMR may be doped with an impurity of the same conductivity type as the impurity doped in the source conductive pattern SCP.

An upper surface or upper end VS1_t of the first vertical patterns VS1 may extend above an upper surface ILD1t of the uppermost first inter-electrode insulating layer ILD1. That is, a second level LV2 of the upper surface or upper end VS1_t of the first vertical patterns VS1 may be higher than a first level LV1 of the upper surface ILD1t of the uppermost first inter-electrode insulating layer ILD1 (e.g., the second level LV2 extends from the substrate 10 or the peripheral circuit structure PS by a greater distance than a distance in which the first level LV1 extends from the substrate 10 or the peripheral circuit structure PS).

The first buried insulating pattern IL may be in an interior of the first vertical patterns VS1. The first buried insulating pattern IL may have a single-layer or multi-layer structure of at least one of silicon oxide, silicon nitride, and silicon oxynitride.

A first gate insulating layer GO1 may be interposed between the first vertical patterns VS1 and the first and second electrode layers GE1 and GE2. The first gate insulating layer GO1 may include a tunnel insulating layer L1, a charge storage layer L2, and a blocking insulating layer L3 sequentially interposed from sidewalls of the first vertical patterns VS1 toward the first and second electrode layers GE1 and GE2. The tunnel insulating layer L1 and the blocking insulating layer L3 may include silicon oxide. The charge storage layer L2 may include silicon nitride. Alternatively, the charge storage layer L2 may be a trap insulating layer, a floating gate electrode, or an insulating layer including conductive nano dots.

A high-k dielectric layer HP may be interposed between the first and second electrode layers GE1 and GE2 and the first and second inter-electrode insulating layers ILD1 and ILD2. The high-k dielectric layer HP may include, for example, a metal oxide. The high-k dielectric layer HP may be extended to be interposed between the first gate insulating layer GO1 and the first and second electrode layers GE1 and GE2.

An upper surface of the first gate insulating layer GO1 may be coplanar with an upper surface ILD1t of the uppermost first inter-electrode insulating layer ILD1.

Third vertical patterns VS3 may extend into the second insulating layer 310, the third electrode layer GE3, and the first insulating layer 305 and may be in contact with the first vertical patterns VS1, respectively. The third vertical patterns VS3 are respectively disposed in upper holes UH. The third vertical patterns VS3 may be formed of a semiconductor layer doped or undoped with impurities (e.g., a silicon layer or a germanium layer). An upper surface of the third vertical patterns VS3 is in contact with the source conductive pattern SCP. A width of the third vertical pattern VS3 may become narrower as the distance between the third vertical pattern VS3 and the first gate insulating layer GO1 decreases. A lower portion of the third vertical patterns VS3 covers or overlaps an upper sidewall of the first vertical patterns VS1 as shown in FIG. 8A.

When viewed in a plan view, a location and arrangement of the third vertical patterns VS3 may be the same as those of the first vertical patterns VS1 of FIG. 5 and may overlap with the first vertical patterns VS1. In another example, the third vertical patterns VS3 may not overlap the string line separation pattern 9. A thickness of the third vertical patterns VS3 may be the same as or different from a thickness of the first vertical patterns VS1. The third vertical pattern VS3 may have a hollow and nonlinear shape (e.g., a macaroni, cylinder, or shell shape).

A second buried insulating pattern 29 may be in the interior of the third vertical pattern VS3. The second buried insulating pattern 29 may have a single-layer or multi-layer structure of at least one of silicon oxide, silicon nitride, and silicon oxynitride. The second buried insulating pattern 29 may be in contact with the upper surface VS1_t of the first vertical pattern VS1 as shown in FIG. 8A. The second buried insulating pattern 29 is spaced apart from the first buried insulating pattern IL. An upper portion of the first vertical pattern VS1 is interposed between the second buried insulating pattern 29 and the first buried insulating pattern IL.

A second gate insulating layer GO2 may be interposed between the third vertical pattern VS3 and the third electrode layer GE3. The second gate insulating layer GO2 may be formed, for example, as a single layer of silicon oxide. A thickness of the second gate insulating layer GO2 may be different from a thickness of the first gate insulating layer GO1. The high-k dielectric layer HP is not interposed between the third electrode layer GE3 and the first and second insulating layers 305 and 310.

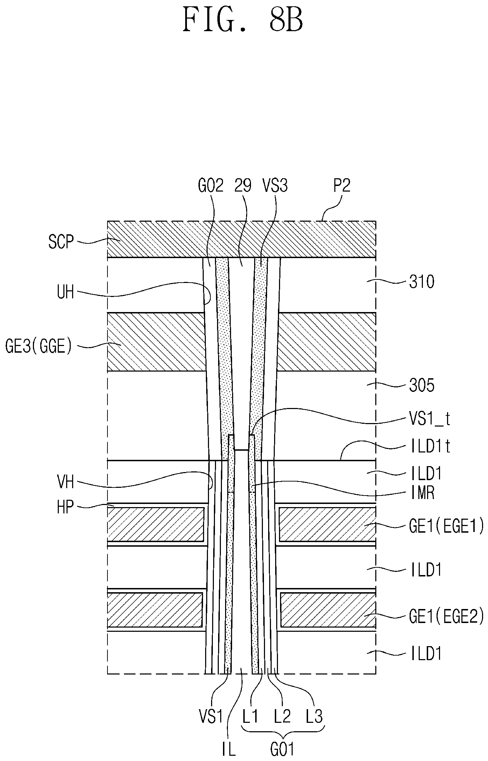

Referring to FIG. 8B, the second buried insulating pattern 29 may extend into the upper potion VS1_t of the first vertical pattern VS1 and may be in contact with the first buried insulating pattern IL. Other structures may be the same/similar to those described with reference to FIG. 8A.

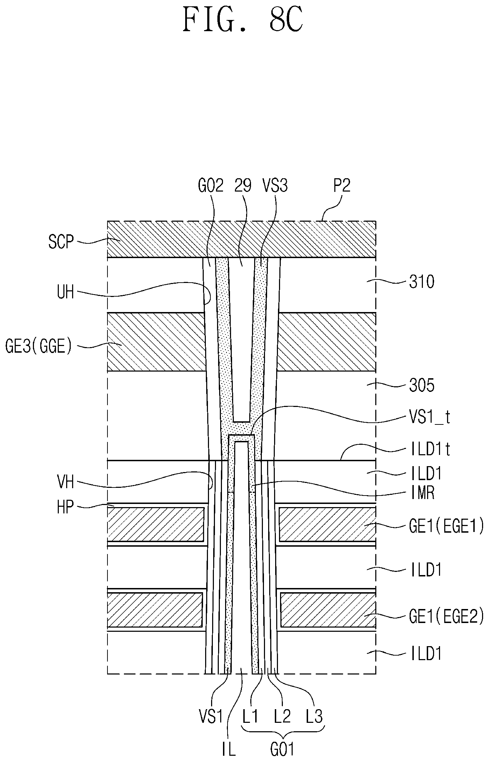

Alternatively, referring to FIG. 8C, a lower portion of the third vertical pattern VS3 may be in contact with the upper portion VS1_t of the first vertical pattern VS1. A lower portion of the third vertical pattern VS3 and the upper portion VS1_t of the first vertical pattern VS1 are interposed between the second buried insulating pattern 29 and the first buried insulating pattern IL. The third vertical pattern VS3 may cover or overlap the upper surface VS1_t of the first vertical pattern VS1 and may have a nonlinear shaped cross section (e.g., a 'U' shaped cross section or an 'H' shaped cross section).

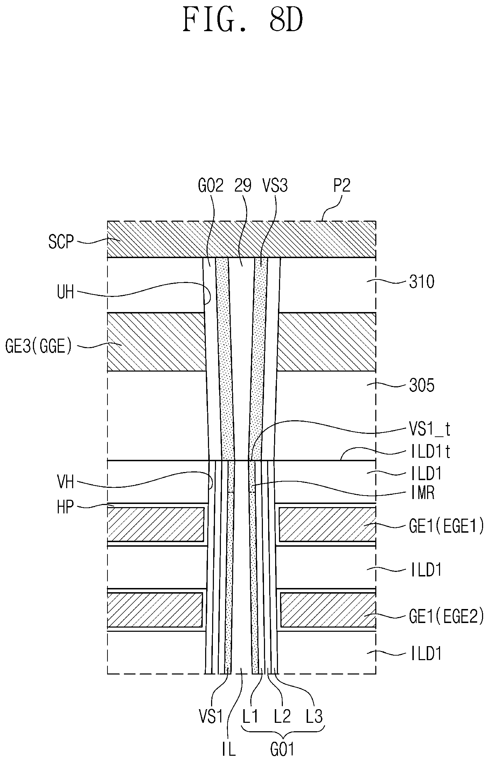

Alternatively, referring to FIG. 8D, the upper surface VS1_t of the first vertical pattern VS1 and the upper surface of the first gate insulating layer GO1 may be coplanar with an upper surface ILD1t of the uppermost first inter-electrode insulating layer ILD1. The second buried insulating pattern 29 may be in contact with the first buried insulating pattern IL.

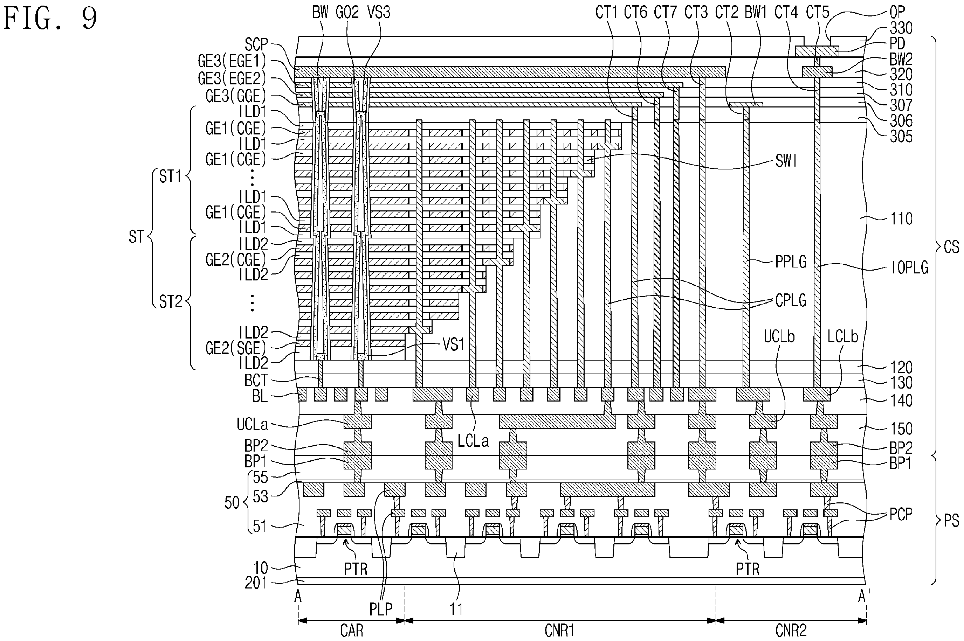

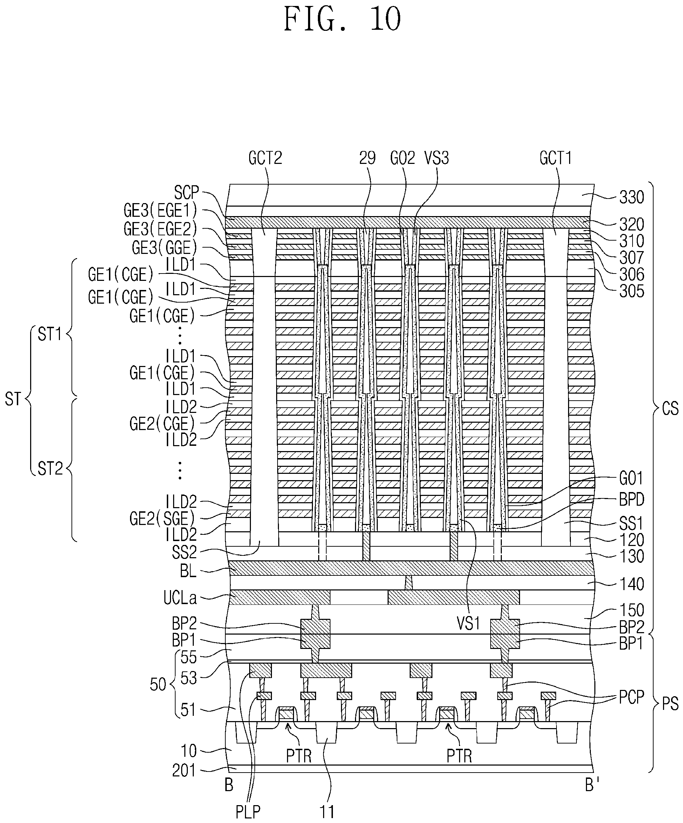

FIG. 9 is a cross-sectional view of a semiconductor memory device according to an embodiment of the present disclosure, taken along line A-A' of FIG. 5. FIG. 10 is a cross-sectional view of a semiconductor memory device according to an embodiment of the present disclosure, taken along line B-B' of FIG. 5.

Referring to FIGS. 9 and 10, in a semiconductor memory device according to the present embodiment, the first electrode layers GE1 may exclude the first and second erase gate patterns EGE1 and EGE2. The first electrode layers GE1 may include only cell gate patterns CGE. The third electrode layer GE3 may be composed of three layers. The third electrode layers GE3 may include first and second erase gate patterns EGE1 and EGE2 and a ground selection gate pattern GGE. A ground selection gate pattern GGE and a first wiring BW1 are disposed on the first insulating layer 305. The ground selection gate pattern GGE and the first wiring BW1 are covered or overlapped with a fourth insulating layer 306. The second erase gate pattern EGE2 is disposed on the fourth insulating layer 306. The second erase gate pattern EGE2 is covered or overlapped with a fifth insulating layer 307. The first erase gate pattern EGE1 is disposed on the fifth insulating layer 307. The first erase gate pattern EGE1 is covered or overlapped with the second insulating layer 310. The third electrode layers GE3 may become longer in the first direction D1 as the distance between the third electrode layers GE3 and the substrate 10 increases. Ends of the third electrode layers GE3 may have an inverted staircase shape.

A sixth contact CT6 extends into the first and fourth insulating layers 305 and 306 and connects the pad portion of the second erase gate pattern EGE2 to one of the cell contact plugs CPLG. A seventh contact CT7 extends into the first, fourth, and fifth insulating layers 305, 306, and 307 and connects the pad portion of the first erase gate pattern EGE1 to another one of the cell contact plugs CPLG. The third contact CT3 extends into the first, fourth, fifth, and second insulating layers 305, 306, 307, and 310 and connects the pad portion of the source conductive pattern SCP to another of the peripheral contact plugs PPLG.

The second vertical pattern VS3 extends into the third electrode layers GE3 and is in contact with the first vertical pattern VS1. The first and second line separation patterns GCT1 and GCT2 extend into the third electrode layers GE3 and are in contact with the block separation pattern SS1 and the first center separation pattern SS2, respectively. Other structures may be the same/similar to those described above.

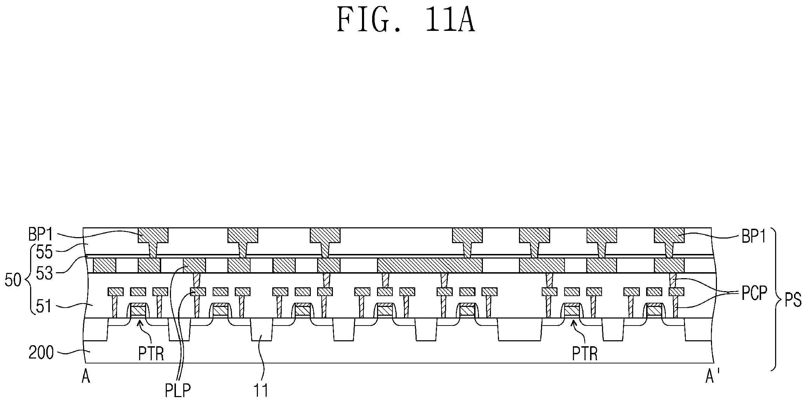

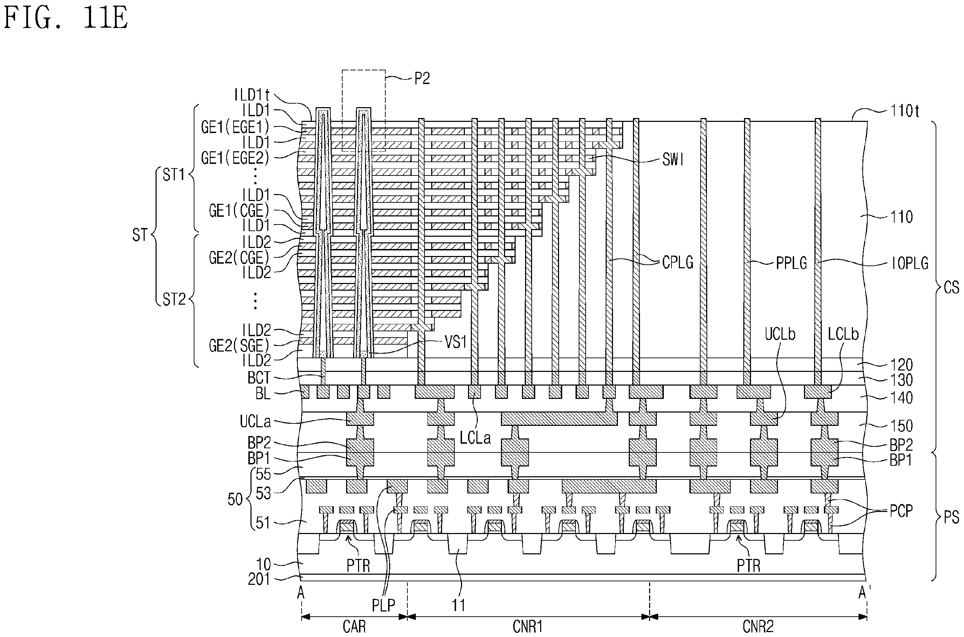

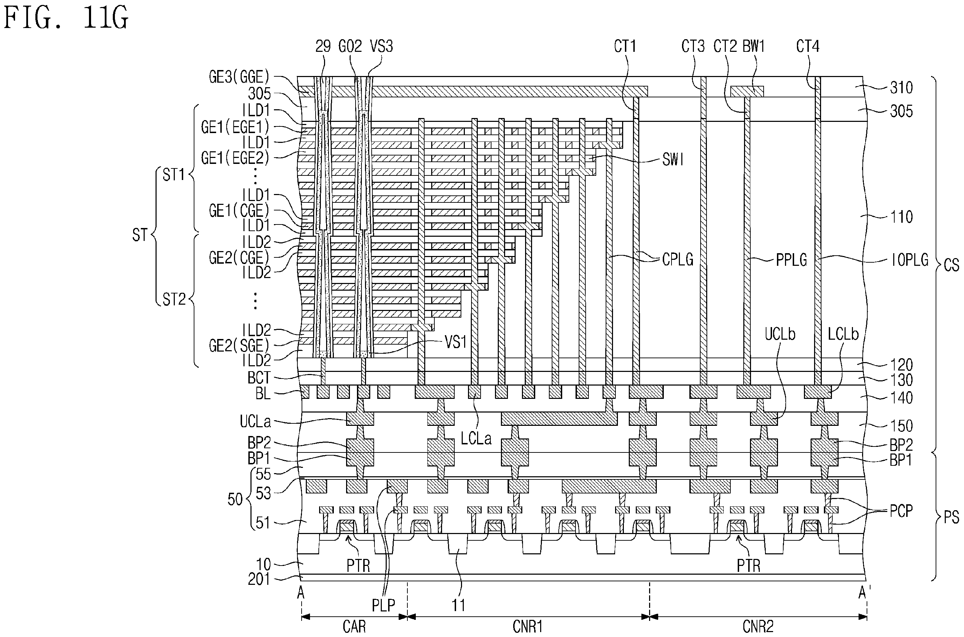

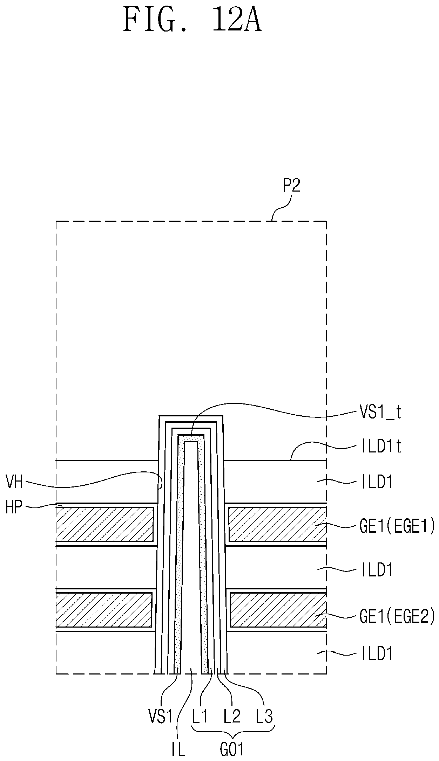

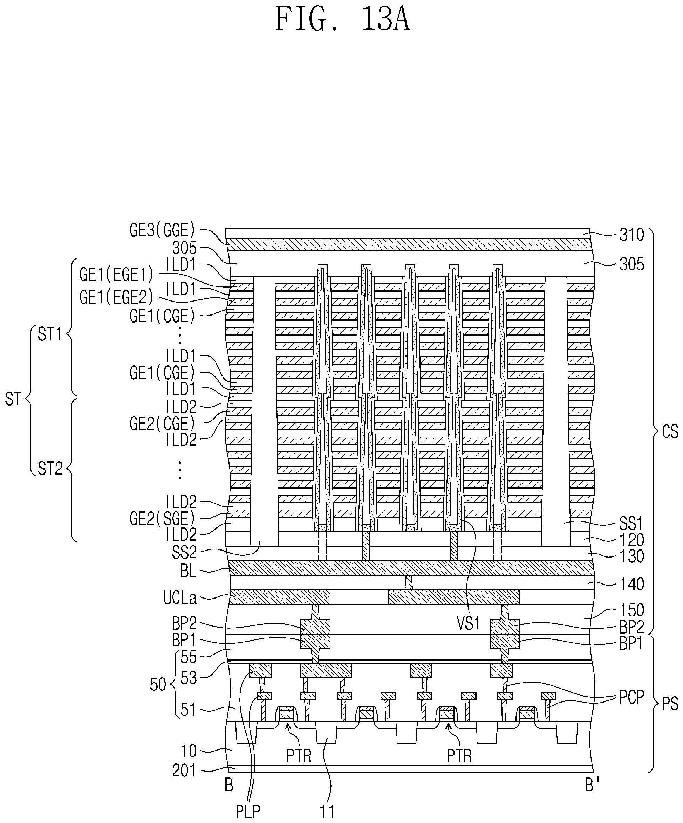

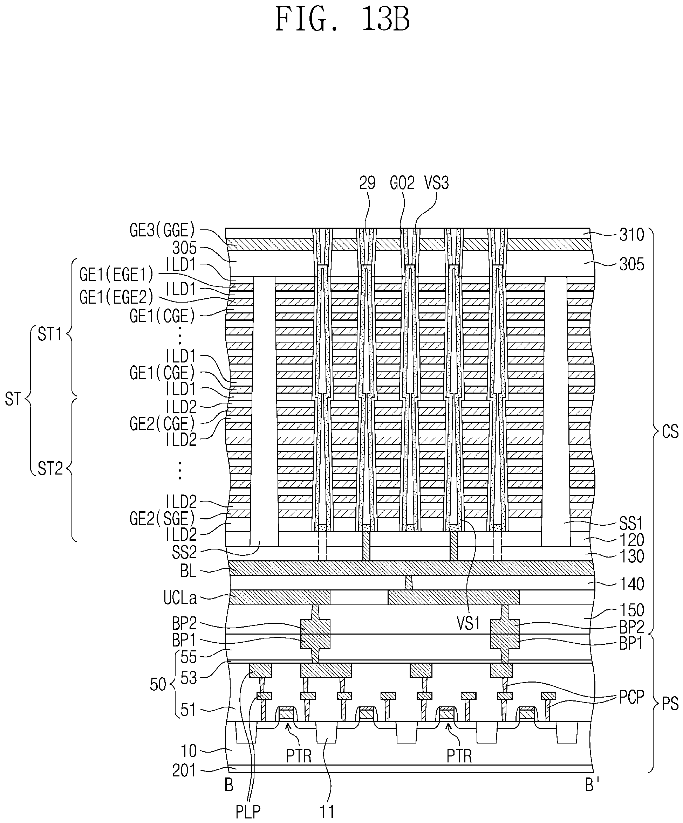

FIGS. 11A to 11H are diagrams sequentially illustrating a process of manufacturing a semiconductor memory device having the cross-section of FIG. 6. FIGS. 12A to 12C are enlarged views of the 'P2' portion of FIG. 11E and sequentially show a process of manufacturing a semiconductor memory device having the cross-section of FIG. 6. FIGS. 13A to 13C are diagrams sequentially illustrating a process of manufacturing a semiconductor memory device having the cross-section of FIG. 7.

Referring to FIG. 11A, a peripheral circuit structure PS including peripheral circuits PTR formed on a first substrate 10 may be formed.

Forming the peripheral circuit structure PS may include forming a device isolation layer 11 that defines an active region within the first substrate 10, forming peripheral circuits PTR on the active region of the first substrate 10, and forming peripheral contact plugs PCP, peripheral circuit wirings PLP, first bonding pads BP1 that are electrically connected to the peripheral circuits PTR, and a peripheral circuit insulating layer 50 thereon.

The first substrate 10 may include, for example, at least one of silicon (Si), germanium (Ge), silicon germanium (SiGe), gallium arsenide (GaAs), indium gallium arsenide (InGaAs), aluminum gallium arsenide (AlGaAs), or mixtures thereof.

Row and column decoders, page buffers, and control circuits may be formed on the first substrate 10 as peripheral circuits PTR. Here, the peripheral circuits PTR may include MOS transistors that use the first substrate 10 as a channel.

The peripheral circuit insulating layer 50 may include one insulating layer or a plurality of stacked insulating layers that cover or overlap the peripheral circuits PTR. As an example, the peripheral circuit insulating layer 50 may include a first lower insulating layer 51, a second lower insulating layer 55, and an etch stop layer 53 between the first and second lower insulating layers 51 and 55. The peripheral circuit insulating layer 50 may include, for example, a silicon oxide layer, a silicon nitride layer, a silicon oxynitride layer, and/or a low-k dielectric layer.

The peripheral contact plugs PCP may be formed to extend into portions of the peripheral circuit insulating layer 50 and be connected to peripheral circuits. The peripheral circuit wirings PLP may be formed by performing a conductive layer deposition process and a conductive layer patterning process.

The first bonding pads BP1 may be formed in the uppermost second lower insulating layer 55 of the peripheral circuit insulating layer 50. The first bonding pads BP1 may be electrically connected to the peripheral circuits PTR through peripheral contact plugs PCP and peripheral circuit wirings PLP.

The first bonding pads BP1 may be formed using a damascene process. Upper surfaces of the first bonding pads BP1 may be substantially coplanar with an upper surface of the second lower insulating layer 55 due to a planarization process that may be performed. The planarization process may be performed, for example, through a chemical mechanical polishing (CMP) process or an etch back process.

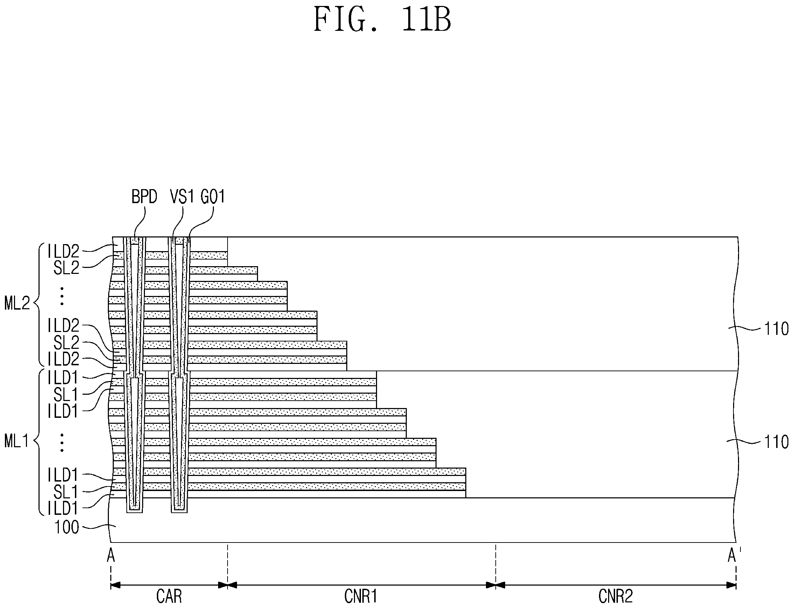

Referring to FIGS. 5 and 11B, a first mold structure ML1 may be formed on a second substrate 100.

Forming the first mold structure ML1 may include forming a first thin film structure (not shown) in which first inter-electrode insulating layers ILD1 and first sacrificial layers SL1 are vertically and alternately stacked, and repeatedly performing patterning processes on the first thin film structure. Accordingly, the first mold structure ML1 may have a stepped structure in a first connection region CNR1.

The first inter-electrode insulating layers ILD1 and the first sacrificial layers SL1 may be deposited using a thermal CVD process, a plasma enhanced CVD process, a physical CVD process, or an atomic layer deposition (ALD) process.

In the first mold structure ML1, the first sacrificial layers SL1 may be formed of a material that may be etched with etch selectivity with respect to the first inter-electrode insulating layers ILD1. For example, the first sacrificial layers SL1 may be formed of an insulating material different from the first inter-electrode insulating layers ILD1. For example, the first sacrificial layers SL1 may be formed of a silicon nitride layer, and the first inter-electrode insulating layers ILD1 may be formed of a silicon oxide layer.

After forming the first mold structure MI,1, a flat insulating layer 110 may be formed covering or overlapping the step structure of the first mold structure ML1.

Subsequently, the second mold structure ML2 may be formed on the first mold structure ML1. According to some embodiments, before forming the second mold structure ML2, vertical sacrificial patterns (not shown) extending into the first mold structure ML1 may be formed.

Forming the second mold structure ML2 may be substantially the same as forming the first mold structure ML1 described above. That is, forming the second mold structure ML2 may include forming a second thin film structure (not shown) in which second inter-electrode insulating layers ILD2 and second sacrificial layers SL2 are vertically and alternately stacked on the first mold structure ML1, and repeatedly performing patterning processes for the second thin film structure. Accordingly, the second mold structure ML2 may have a stepped structure in the first connection region CNR1.

The second sacrificial layers SL2 may be formed of the same material as the first sacrificial layers SL1, and a thickness of the second sacrificial layers SL2 may be substantially the same as that of the first sacrificial layers SL1. The second sacrificial layers SL2 may be formed of an insulating material different from the second inter-electrode insulating layers ILD2. The second sacrificial layers SL2 may be formed of the same material as the first sacrificial layers SL1. For example, the second sacrificial layers SL2 may be formed of a silicon nitride layer, and the second inter-electrode insulating layers ILD2 may be formed of a silicon oxide layer.

After forming the second mold structure ML2, a flat insulating layer 110 may be formed covering overlapping a step structure of the second mold structure ML2.

Subsequently, vertical channel holes that penetrate the first and second mold structures ML1 and ML2 and expose the second substrate 100 may be formed. When vertical sacrificial patterns (not shown) are formed in the first mold structure ML1, forming vertical channel holes may include removing the vertical sacrificial patterns to expose the second substrate 100.

When forming vertical channel holes, dummy channel holes that extend into the flat insulating layer 110 and portions of the first and second mold structures ML1 and ML2 may be formed in the first connection region CNR1.

Forming the vertical channel holes may include forming a hard mask pattern on the second mold structure ML2 and anisotropically etching the first and second mold structures ML1 and ML2 using the hard mask pattern as an etch mask. In the anisotropic etching process for forming vertical channel holes, an upper surface of the second substrate 100 may be over-etched, and accordingly, the upper surface of the second substrate 100 exposed to the vertical channel holes may be recessed to a certain depth. Additionally, during the anisotropic etching process for forming the vertical channel holes, the recess depth of the second substrate 100 may vary depending on positions of the vertical channel holes.

Subsequently, first vertical patterns VS1 may be formed in the vertical channel holes of the cell array region CAR, and second vertical patterns VS2 may be formed in the dummy channel holes of the first connection region CNR1.

Forming the first and second vertical patterns VS1 and VS2 may include sequentially depositing a first gate insulating layer GO1 and a first vertical pattern VS1 in the vertical channel holes, and etching and planarizing the first gate insulating layer GO1 and the first vertical pattern VS1.

Referring to FIG. 8A, the first gate insulating layer GO1 may be deposited with a uniform thickness on bottom surfaces and inner walls of the vertical channel holes VH using a chemical vapor deposition (CVD) or atomic layer deposition (ALD) method. The first gate insulating layer GO1 may include a blocking insulating layer L3, a charge storage layer L2, and a tunnel insulating layer L1 sequentially stacked in vertical channel holes. The first vertical pattern VS1 may be deposited with a uniform thickness on the first gate insulating layer GO1 using a chemical vapor deposition (CVD) or atomic layer deposition (ALD) method. After forming the first gate insulating layer GO1 and the first vertical pattern VS1, the vertical channel holes VH may be filled with a first buried insulating pattern IL.

Subsequently, bit line conductive pads BPD may be formed on an upper end of the first vertical pattern VS1. The bit line conductive pads BPD may be impurity regions doped with impurities or may be formed of a conductive material. Upper surfaces of the bit line conductive pads BPD may be coplanar with an upper surface of the uppermost second inter-electrode insulating layer ILD2.

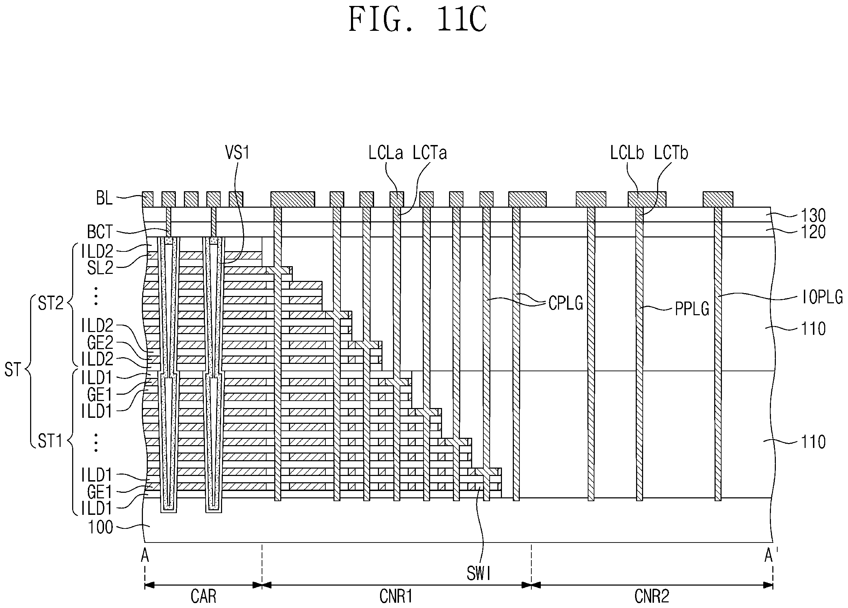

Referring to FIGS. 5 and 11C, a first interlayer insulating layer 120 may be formed on the flat insulating layer 110 to cover or overlap the upper surfaces of the first and second vertical patterns VS1 and VS2.

Subsequently, a process of replacing the first and second sacrificial layers SL1 and SL2 of the first and second mold structures ML1 and ML2 with first and second electrode layers GE1 and GE2 may be performed. Accordingly, a stacked structure ST may be formed on the second substrate 100.

The process of replacing the first and second sacrificial layers SL1 and SL2 with the first and second electrode layers GE1 and GE2 may include isotropically etching the first and second sacrificial layers SL1 and SL2 using an etch recipe having etch selectivity with respect to the first and second inter-electrode insulating layers ILD1 and ILD2, the first and second vertical patterns VS1 and VS2, and the second substrate 100. After forming the stacked structure ST, a block separation pattern SS1, a first center separation pattern SS2, and a second center separation pattern SS3 of FIGS. 5, 7, and 13A may be formed.

Afterwards, a second interlayer insulating layer 130 may be formed on the first interlayer insulating layer 120, and cell contact plugs CPLG, peripheral contact plugs PPLG, and an input/output contact plug IOPLG that connected to the stacked structure ST may be formed.

The peripheral contact plugs PPLG and the input/output contact plug IOPLG may be formed by forming contact holes in the first interlayer insulating layers 120 and the flat insulating layer 110 in the second connection region CNR2 to expose the second substrate 100 and then, by depositing a conductive material in the contact hole.

A second interlayer insulating layer 130 may be formed on the first interlayer insulating layer 120, and bit line contact plugs BCT of the cell array region CAR and connection contact plugs of first and second connection regions CNR1 and CNR2 may be formed.

The bit line contact plugs BCT may extend into the first and second interlayer insulating layers 120 and 130 and be connected to the first vertical patterns VS1. The bit line contact plugs BCT may be in contact with the bit line conductive pad. The bit line conductive pad may be formed of an undoped semiconductor material, a semiconductor material doped with impurities, or a conductive material.

The first connection contact plugs may extend into the second interlayer insulating layer 130 and be connected to the cell contact plugs CPLG. The second connection contact plugs may extend into the second interlayer insulating layer 130 and be connected to the peripheral contact plugs PPLG and the input/output contact plug IOPLG.

Bit lines BL and lower conductive lines LCLa and LCLb may be formed on the second interlayer insulating layer 130. The bit lines BL may be connected to bit line contact plugs BCT, and the lower conductive lines LCLa and LCLb may be connected to connection contact plugs.

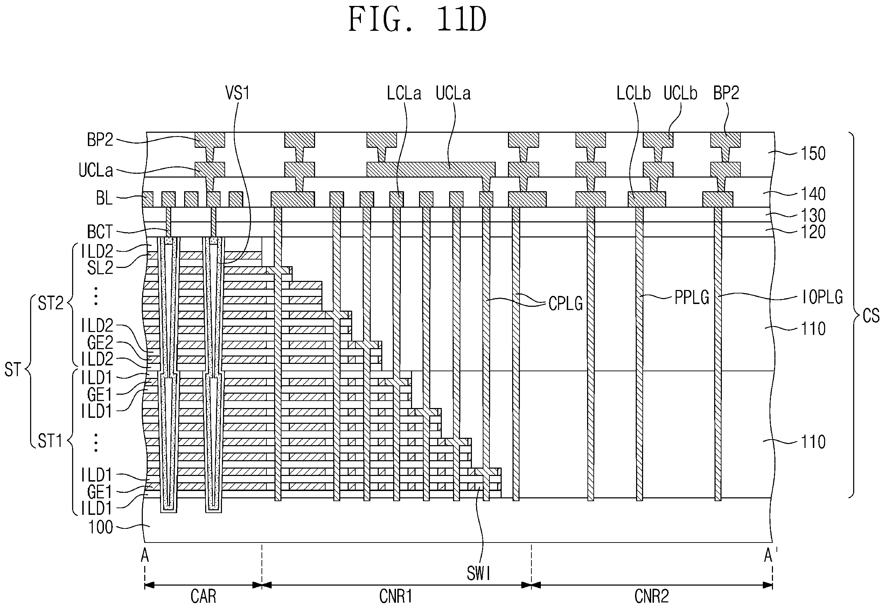

Referring to FIGS. 5 and 11D, third and fourth interlayer insulating layers 140 and 150 may be deposited on the second interlayer insulating layer 130, and first and second upper conductive lines UCLa and UCLb may be formed on the third interlayer insulating layer 140. The first and second upper conductive lines UCLa and UCLb may be connected to the first and second lower conductive lines LCLa and LCLb.

Second bonding pads BP2 may be formed in the fourth interlayer insulating layer 150, and the second bonding pads BP2 may be connected to the first and second upper conductive lines UCLa and UCLb.

The first and second upper conductive lines UCLa and UCLb and the second bonding pads BP2 may be formed using a damascene process. Upper surfaces of the second bonding pads BP2 may be substantially coplanar with an upper surface of the fourth interlayer insulating layer 150.

Referring to FIGS. 5, 11D, and 11E, a cell array structure CS formed on the second substrate 100 and a peripheral circuit structure PS formed on the first substrate 10 by the method described with reference to FIG. 10 may be bonded to each other. In detail, the first bonding pads BP1 of the peripheral circuit structure PS and the second bonding pads BP2 of the cell array structure CS may be bonded to each other.

Accordingly, the first bonding pads BP1 and the second bonding pads BP2 may be bonded to each other, and the second lower insulating layer 55 on the first substrate 10 and the fourth interlayer insulating layer 150 on the second substrate 100 may be bonded to each other.

As the first bonding pads BP1 and the second bonding pads BP2 are bonded to each other, the cell array structure CS may be inverted. That is, the second substrate 100 of the cell array structure CS may be positioned at the uppermost end, and the staircase structure of the stacked structure ST may be arranged in an inverted form.

Referring to FIGS. 11E and 12A, after the first bonding pads BP1 and the second bonding pads BP2 are bonded to each other, the second substrate 100 may be removed. Removing the second substrate 100 may include a grinding process, a planarization process, a dry etching process, and a wet etching process. As the second substrate 100 is removed, an upper surface 110t of the lowermost first inter-electrode insulating layer ILD1 and an upper surface 110t of the flat insulating layer 110 of the stacked structure ST may be exposed. Additionally, as the second substrate 100 is removed, upper portions of the first vertical patterns VS1 and the first gate insulating layer GO1 covering or overlapping the first vertical patterns VS1 may extend on the lowermost first inter-electrode insulating layer ILD1, and the peripheral contact plugs PPLG and input/output contact plug IOPLG may be exposed.

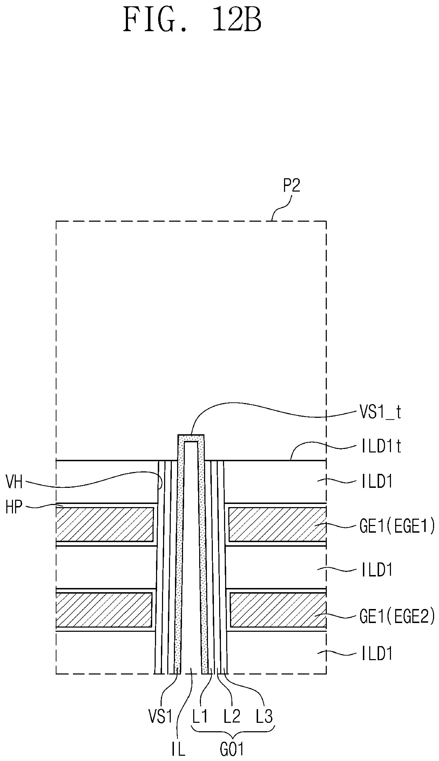

Referring to FIG. 12B, an upper portion of the first gate insulating layer GO1 extending above the lowermost first inter-electrode insulating layer ILD1 may be removed to expose an upper surface VS1_t of the first vertical pattern VS1.

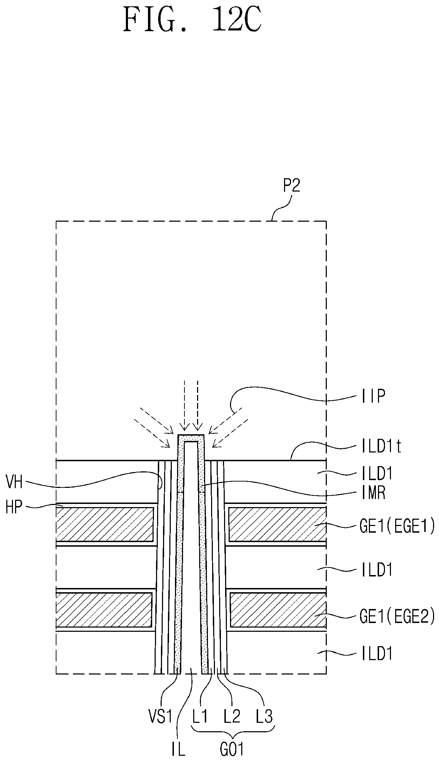

Referring to FIG. 12C, an ion implantation process is performed to form a first impurity region IMR on an upper portion of the first vertical pattern VS1. The first impurity region IMR may be doped with, for example, an N-type impurity.

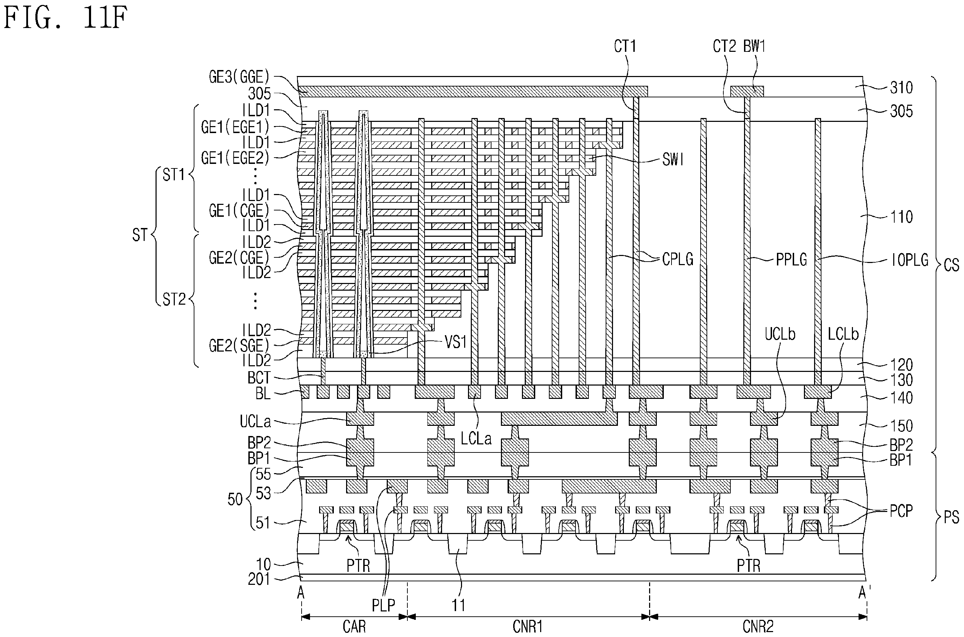

Referring to FIGS. 11F and 13A, the first insulating layer 305 may be deposited on the stacked structure ST and a planarization process may be performed. The first insulating layer 305 may be in contact with the first vertical patterns VS1, the cell contact plugs CPLG, the peripheral contact plugs PPLG, and the input/output contact plug IOPLG. The first insulating layer 305 may be etched to form first contact holes exposing at least one of the outermost cell contact plug CPLG and peripheral contact plugs PPLG. The first contact holes are filled with a conductive layer to form first and second contacts CT1 and CT2. The conductive layer is deposited on the first insulating layer 305 and etched to form a third electrode layer GE3 and a first wiring BW1. The third electrode layer GE3 is formed to be in contact with the first contact CT1. The first wiring BW1 is formed to be in contact with the second contact CT2. A second insulating layer 310 is formed to cover or overlap the third electrode layer GE3 and the first wiring BW1.

Referring to FIGS. 5, 8A, 11G, and 13B, the second insulating layer 310, the third electrode layer GE3, and the first insulating layer 305 are etched in the cell array region CAR to form an upper hole UH exposing the first vertical pattern VS1. A second gate insulating layer GO2 is conformally deposited on the second insulating layer 310 and then anisotropically etched. As a result, a second gate insulating layer GO2 may be formed that covers or overlaps the inner wall of the upper hole UH and exposes the first vertical pattern VS1. After conformally depositing a semiconductor layer on the second insulating layer 310, an anisotropic etching process is performed to form a third vertical pattern VS3 covering or overlapping the sidewall of the second gate insulating layer GO2. A second buried insulating layer is deposited on the second insulating layer 310 and in the upper hole UH, and an anisotropic etching process is performed to expose an upper end of the third vertical pattern VS3 and to form a second buried insulating pattern 29 in the upper hole UH. Then, the second insulating layer 310 and the first insulating layer 305 in the second connection region CNR2 are etched to form second contact holes that expose at least one of the peripheral contact plugs PPLG and the input/output contact plug IOPLG. The second contact holes are filled with a conductive layer to form third and fourth contacts CT3 and CT4.

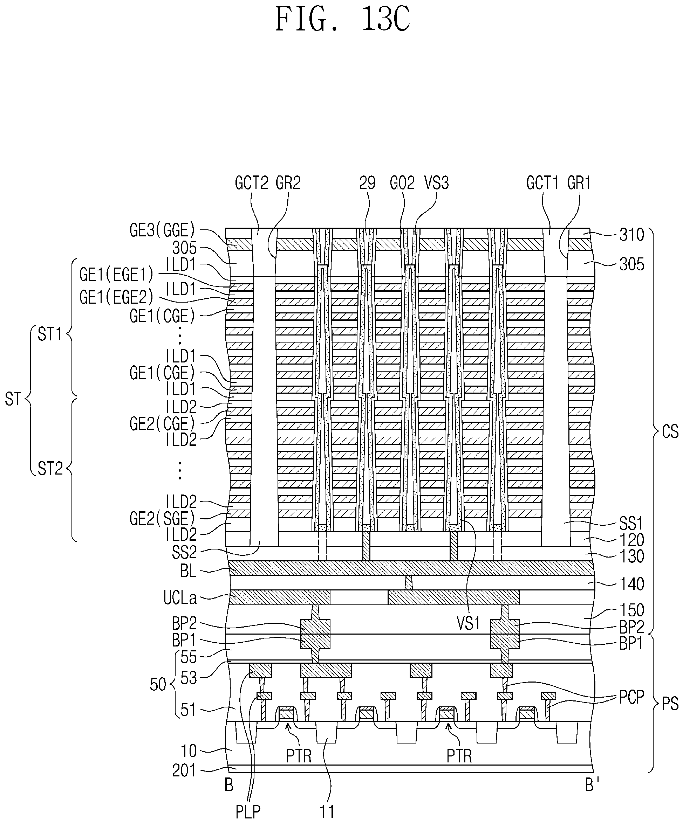

Referring to FIGS. 5 and 13C, the second insulating layer 310, the third electrode layer GE3, and the first insulating layer 305 in the cell array region CAR and the first connection region CNR1 are etched to form a first groove GR1 exposing the block separation pattern SS1 and a second groove GR2 exposing the first center separation pattern SS2. After depositing an insulating layer on the second insulating layer 310 to fill the first groove GR1 and the second groove GR2, an etch-back process or a polishing process is performed to form a first line separation pattern GCT1 and a second line separation pattern GCT2 in the first groove GR1 and the second groove GR2, respectively, and to expose an upper surface of the third vertical pattern VS3.

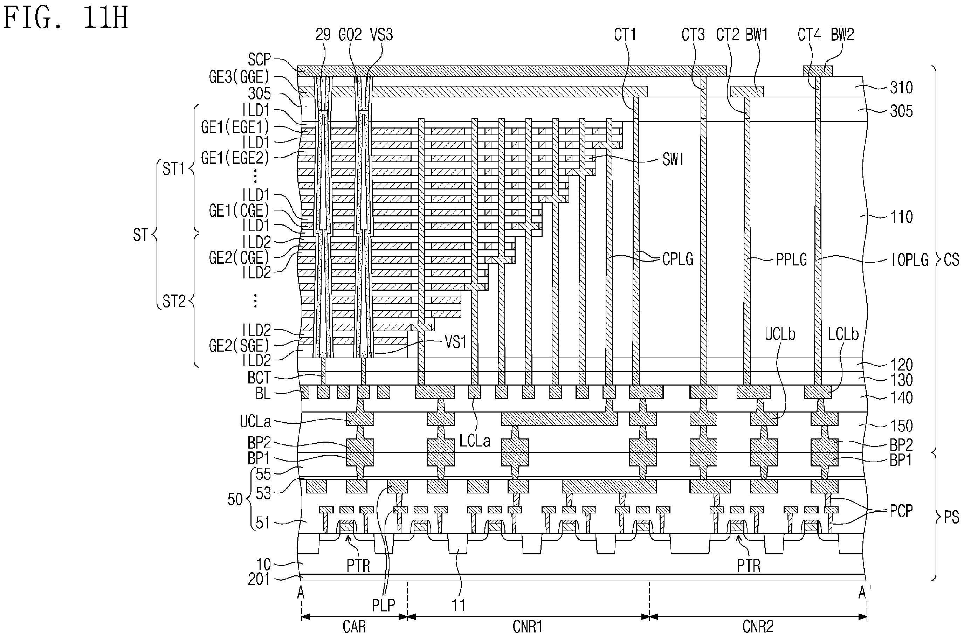

Referring to FIG. 11H, a conductive layer is deposited on the second insulating layer 310 and etched to form a source conductive pattern SCP and a second wiring BW2. The source conductive pattern SCP and the second wiring BW2 are formed of a conductive layer, for example, polysilicon doped with N-type impurities.

Referring again to FIGS. 6 and 7, a third insulating layer 320 is formed to cover the source conductive pattern SCP and the second wiring BW2. A fifth contact CT5 is formed inside the third insulating layer 320. An input/output pad PD is formed on the third insulating layer 320. A passivation layer 330 is formed on the third insulating layer 320. A portion of the passivation layer 330 is removed to form a pad opening OP exposing the input/output pad PD. Therefore, the semiconductor memory device of FIGS. 5 to 7 may be manufactured.

Conventionally, the stacked structure ST has been formed to include ground selection lines GGE and first and second line separation patterns GCT1 and GCT2, and the first and second electrode layers GE1 and GE2 have been formed to be curved in a 'seagull' shape by the first and second line separation patterns GCT1 and GCT2. As a result, a contact defect has occurred where some of the first and second electrode layers GE1 and GE2 are in contact with each other, or an operation error has occurred because the first and second electrode layers GE1 and GE2 are not spaced apart with more than a certain distance.

However, in the present disclosure, after forming the stacked structure ST, the first and second line separation patterns GCT1 and GCT2 may be formed to separate the ground selection lines GGE, and thus the first and second electrode layers GE1 and GE2 may be formed to be flat. As a result, the 'seagull' shape word line contact defect may be prevented, thereby improving reliability of the semiconductor memory device.

In the semiconductor memory device according to the present disclosure, the first and second line separation patterns that separate the ground selection lines are disposed on the stacked structure, and thus the first and second electrode layers of the stacked structure may be formed to be flat. This may inhibit the 'seagull' shape word line contact defects and may improve the reliability of the semiconductor memory device.

While embodiments are described above, a person skilled in the art may understand that many modifications and variations are made without departing from the scope of the present disclosure defined in the following claims. Accordingly, the example embodiments of the present disclosure should be considered in all respects as illustrative and not restrictive, with the scope of the present disclosure being indicated by the appended claims.

## Claims

1. A semiconductor memory device comprising:
a peripheral circuit structure comprising peripheral circuits;
a stacked structure on the peripheral circuit structure and comprising first electrode layers and first inter-electrode insulating layers that are alternately stacked;
a first vertical pattern that extends into the stacked structure;
a first insulating layer on the stacked structure, a second electrode layer on the first insulating layer, and a second insulating layer on the second electrode layer;
a line separation pattern that extends into the second insulating layer, the second electrode layer, and the first insulating layer; and
a second vertical pattern that extends into the second insulating layer, the second electrode layer, and the first insulating layer, wherein the second vertical pattern is electrically connected to the first vertical pattern.

2. The semiconductor memory device of claim 1, further comprising a plurality of the line separation patterns, wherein the plurality of line separation patterns separate the second electrode layer into a plurality of ground selection lines.

3. The semiconductor memory device of claim 2, wherein the plurality of line separation patterns comprise first line separation patterns and second line separation patterns,
wherein the semiconductor memory device further comprises:
block separation patterns that extend into the stacked structure and separate the stacked structure into a plurality of blocks; and
center separation patterns that extend into the stacked structure and are respectively at a center of each of the plurality of blocks,
wherein the first line separation patterns are respectively on the block separation patterns, and
wherein the second line separation patterns are respectively on the center separation patterns.

4. The semiconductor memory device of claim 3, wherein:
the stacked structure comprises a cell array region and a connection region,
the first line separation patterns, the second line separation patterns, and the block separation patterns are continuous in both the cell array region and the connection region, and
each of the center separation patterns comprises a discontinuous section in the connection region.

5. The semiconductor memory device of claim 1, wherein an upper surface of the line separation pattern and an upper surface of the second vertical pattern are coplanar with an upper surface of the second insulating layer.

6. The semiconductor memory device of any preceding claim, further comprising a source layer that is on the second insulating layer and on the second vertical pattern.

7. The semiconductor memory device of any preceding claim, further comprising at least one third electrode layer on the second insulating layer, wherein the second vertical pattern extends into the at least one third electrode layer.

8. The semiconductor memory device of claim 7, wherein a portion of the at least one third electrode layer is adjacent to the second electrode layer, and
wherein the semiconductor memory device further comprises:
a first contact that extends into the first insulating layer and that is electrically connected to the second electrode layer and the peripheral circuit structure; and
a second contact that extends into the first insulating layer and the second insulating layer and that is electrically connected to the third electrode layer and the peripheral circuit structure.

9. The semiconductor memory device of any preceding claim, wherein:
an upper end of the first vertical pattern extends from the peripheral circuit structure by a first distance;
an upper surface of the stacked structure extends from the peripheral circuit structure by a second distance;
the first distance is greater than or equal to the second distance; and
the semiconductor memory device further comprises a first impurity region on the upper end of the first vertical pattern.

10. The semiconductor memory device of any preceding claim, further comprising:
a first gate insulating layer between the first vertical pattern and the first electrode layers; and
a second gate insulating layer between the second vertical pattern and the second electrode layer,
wherein the first gate insulating layer comprises a tunnel insulating layer, a charge storage layer on the tunnel insulating layer, and a blocking insulating layer on the charge storage layer,
wherein the first gate insulating layer extends from a side of the first vertical pattern toward a side surface of the stacked structure, and
wherein the second gate insulating layer does not comprise the charge storage layer.

11. The semiconductor memory device of claim 10, further comprising a high-k dielectric layer between the first electrode layers and the first gate insulating layer, wherein the second electrode layer is directly on the second gate insulating layer.

12. The semiconductor memory device of any preceding claim, wherein the second vertical pattern overlaps an upper surface of the first vertical pattern and has a nonlinear shaped cross section.
